(19) Europäisches Patentamt
European Patent Office
Office européen des brevets

(11) EP 4 804 237 A1

(12) # EUROPEAN PATENT APPLICATION

published in accordance with Art. 153(4) EPC

(43) Date of publication:
**09.09.2026 Bulletin 2026/37**

(21) Application number: **24897597.1**

(22) Date of filing: **27.11.2024**

(51) International Patent Classification (IPC):
***H01L 21/60*** *(2006.01)* ***C22C 21/02*** *(2006.01)*
***C22F 1/00*** *(2006.01)* ***C22F 1/043*** *(2006.01)*

(52) Cooperative Patent Classification (CPC):
**C22C 21/00; C22C 21/02; C22F 1/00; C22F 1/04; C22F 1/043; H10W 72/071**

(86) International application number:
**PCT/JP2024/042018**

(87) International publication number:
**WO 2025/115913 (05.06.2025 Gazette 2025/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority:
**27.11.2023 PCT/JP2023/042366**
**27.11.2023 PCT/JP2023/042369**
**27.11.2023 PCT/JP2023/042371**
**27.11.2023 PCT/JP2023/042373**
**27.11.2023 PCT/JP2023/042374**
**04.06.2024 PCT/JP2024/020313**
**04.06.2024 PCT/JP2024/020314**

(71) Applicants:
- **NIPPON STEEL CHEMICAL & MATERIAL CO., LTD.**
  **Tokyo 103-0027 (JP)**
- **Nippon Micrometal Corporation**
  **Iruma-shi**
  **Saitama 358-0032 (JP)**

(72) Inventors:
- **UNO, Tomohiro**
  **Tokyo 100-8071 (JP)**
- **ODA, Daizo**
  **Iruma-shi, Saitama 358-0032 (JP)**
- **ETO, Motoki**
  **Iruma-shi, Saitama 358-0032 (JP)**
- **YAMAGUCHI, Tadashi**
  **Iruma-shi, Saitama 358-0032 (JP)**
- **KOZAWA, Norihiro**
  **Iruma-shi, Saitama 358-0032 (JP)**

(74) Representative: **Grünecker Patent- und Rechtsanwälte**
**PartG mbB**
**Leopoldstraße 4**
**80802 München (DE)**

(54) **AL BONDING WIRE OR AL BONDING RIBBON**

(57) To provide an Al bonding wire or an Al bonding ribbon that exhibits excellent temperature cycle reliability even in a temperature cycle test having a large number of cycles, which is required for next-generation SiC power semiconductors. The Al bonding wire or the Al bonding ribbon contains 3.0 % by mass or more and 20.0 % by mass or less of Si, wherein, when a crystal orientation of an Al phase in an L cross-section (cross section in a center axis direction including a center axis) of the Al bonding wire or the Al bonding ribbon is measured, an orientation ratio of a <110> crystal orientation angled at 15° or less to a direction perpendicular to the center axis (ND direction) is equal to or larger than 10% and equal to or smaller than 40%, and an orientation ratio of a <100> crystal orientation angled at 15° or less to a direction parallel to the center axis (RD direction) is equal to or larger than 15% and equal to or smaller than 50%.

EP 4 804 237 A1

## Description

## TECHNICAL FIELD

The present invention relates to an Al bonding wire or an Al bonding ribbon. The present invention further relates to a semiconductor device obtained by using the Al bonding wire or the Al bonding ribbon.

## BACKGROUND ART

In a semiconductor device, electrodes formed on a semiconductor chip are connected with a lead frame or electrodes on a substrate via a bonding wire (wire material) or a bonding ribbon (bar material). In a power semiconductor device, used is a bonding wire or a bonding ribbon made mainly of aluminum (Al) as a material. A wire diameter of the Al bonding wire mainly falls within a range from 100 μm to 600 μm. A width of the Al bonding ribbon mainly falls within a range from 100 μm to 3000 μm, and a thickness thereof falls within a range from 50 μm to 600 um. Herein, the Al bonding wire and the Al bonding ribbon are collectively referred to as an Al connection material.

In the power semiconductor device, silicon (Si) is often used as a material of a semiconductor chip, and an Al-Si alloy or an Al-Cu alloy is often used as a material of the electrode formed on the semiconductor chip. Power semiconductor devices using the Al bonding wire or the Al bonding ribbon are often used as large power equipment such as air conditioners and photovoltaic power generation systems, or as vehicle-mounted semiconductor devices.

A bonding method for the Al bonding wire or the Al bonding ribbon includes 1st bonding with the electrode on the semiconductor chip and 2nd bonding with the lead frame or the electrode on the substrate, and wedge bonding is used for both of them. The wedge bonding is a method for applying ultrasonic vibrations and loads to the Al bonding wire or the Al bonding ribbon via a jig (tool) made of metal, breaking surface oxide films of the Al bonding wire or the Al bonding ribbon and an electrode material to expose new surfaces, and performing solid phase diffusion bonding. This connection method is characterized in that the connection material is connected in a solid phase state without being melted, which is a bonding technique different from a welding technique of melting the connection material.

A next-generation power semiconductor device is required to stably operate for a long time as compared with a general-purpose power semiconductor device. The power semiconductor device operates while repeatedly turning on and off a current. When a current is supplied to a semiconductor chip made of Si via the Al bonding wire or the Al bonding ribbon, a temperature of a 1st bonding part rises. On the other hand, when supply of the current is stopped, the temperature of the 1st bonding part falls. In this way, the temperature of the 1st bonding part repeatedly rises and falls at the time when the power semiconductor operates. Accordingly, thermal stress, which is caused by a thermal expansion difference between the Al bonding wire or the Al bonding ribbon and the semiconductor chip, is repeatedly applied to the 1st bonding part. In a case of using a connection material made only of high-purity Al, the Al bonding wire or the Al bonding ribbon is broken in a relatively short time due to thermal stress, so that it has been difficult to satisfy performance required for the next-generation power semiconductor device. Thus, in the next-generation power semiconductor, it is required to improve a lifetime of wire (or ribbon) bond accompanying a temperature rise and a temperature fall of the 1st bonding part (hereinafter, also referred to as "temperature cycle reliability").

In response to the requirement for the temperature cycle reliability, there has been developed an Al bonding wire focused on improvement in mechanical strength. As a method for improving a mechanical characteristic of the Al bonding wire, there has been developed a method for adding a specific element to Al.

Patent Literature 1 discloses a bonding wire made of an Al alloy containing at least magnesium (Mg) and silicon (Si), in which a total content of Mg and Si is equal to or larger than 0.03% by mass and equal to or smaller than 0.3% by mass. This Patent Literature discloses that lowering of bonding strength of the 1st bonding part is delayed in a thermal cycle test in a temperature range from 70°C to 120°C due to a high-strengthening effect exhibited by solid-solution strengthening of Mg or Si, and an effect of suppressing crack development exhibited by precipitated magnesium silicide ($Mg_2Si$).

Patent Literature 2 discloses a bonding wire made of an alloy containing 0.01 to 0.2% by mass of iron (Fe), 1 to 20 mass ppm of silicon (Si), and Al having purity of 99.997% by mass or more as a balance, in which a solid solution amount of Fe is 0.01 to 0.06%, a precipitation amount of Fe is 7 times or less the Fe solid solution amount, and the bonding wire has a fine structure having an average crystal grain size of 6 to 12 μm. This Patent Literature discloses that it is possible to suppress lowering of bonding strength of a 1st bonding part in a thermal shock test within a temperature range from -50°C to 200°C by uniformly dispersing intermetallic compound particles of Fe and Al in Al to improve mechanical strength of a matrix and further refining recrystallized grains.

Patent Literature 3 discloses a bonding wire made by melting an Al-Si alloy containing 0.1 to 5% by mass of silicon (Si), and Al and impurities as a balance, and jetting and rapidly cooling it to be formed in a thin line. This Patent Literature discloses that mechanical strength is improved by rapidly cooling the melted Al-Si alloy to finely and uniformly disperse Si.

## RELATED ART REFERENCE

### Patent Literature

Patent Literature 1: Japanese Patent Application Laid-open No. 2014-131010
Patent Literature 2: Japanese Patent Application Laid-open No. 2014-129578
Patent Literature 3: Japanese Patent Application Laid-open No. S59-57440

## SUMMARY OF INVENTION

### PROBLEM TO BE SOLVED BY THE INVENTION

As described above, the next-generation power semiconductor device is required to withstand a longer-time use as compared with a general-purpose power semiconductor device. The temperature of the 1st bonding part repeatedly rises and falls at the time when the power semiconductor device operates. As a result, because the Al bonding wire or the Al bonding ribbon has a coefficient of linear thermal expansion larger than that of the semiconductor chip, there has been a case in which thermal stress is caused due to a difference between coefficients of linear thermal expansion thereof at the 1st bonding part, which finally causes fatigue breakdown of the Al bonding wire or the Al bonding ribbon. A temperature cycle test is one of the tests for evaluating, in an accelerated manner, a lifetime of wire (or ribbon) bond accompanying a temperature rise and a temperature fall of the 1st bonding part (temperature cycle reliability). The Al bonding wire or the Al bonding ribbon used for the next-generation power semiconductor is required to exhibit excellent temperature cycle reliability in the temperature cycle test.

In next-generation power semiconductor elements that replace silicon (Si), which has been mainstream, use of silicon carbide (SiC) having high heat resistance is predicted to advance. In a connection for a SiC power semiconductor, a temperature cycle test that is more severe than a current temperature cycle test is required. For example, the number of cycles of the temperature cycle test for a Si semiconductor is about 1000 cycles, whereas for a SiC semiconductor, the number of cycles is required to be extended to about 2000 cycles. An upper limit temperature for a Si semiconductor is required to be about 150°C, which is a severe condition, whereas for a SiC semiconductor, excellent temperature cycle reliability is required to be exhibited under a more severe condition, such as a temperature exceeding 175°C. Herein, the present inventors have found that, even in a case of the Al bonding wire or the Al bonding ribbon that exhibits excellent temperature cycle reliability at about 1000 cycles, when the number of cycles of the temperature cycle test is set to 2000 cycles for a SiC semiconductor, a problem may arise in that the strength of a bonding part of the Al bonding wire or the Al bonding ribbon deteriorates, and the temperature cycle reliability may be inferior. This is considered to be because, as the number of temperature cycles increases, a form, a location, and an extension behavior of a crack generated at the bonding part of the Al bonding wire or the Al bonding ribbon change. Therefore, when the number of cycles increases from 1000 cycles to 2000 cycles, a ratio of cracks generated inside the Al bonding wire or the Al bonding ribbon rapidly increases, and this is considered to be a factor that accelerates a decrease in reliability.

The present invention has been made in view of the above problem, and aims at providing an Al bonding wire or an Al bonding ribbon that exhibits excellent temperature cycle reliability even in a temperature cycle test having a large number of cycles, which is required for next-generation SiC power semiconductors.

### MEANS FOR SOLVING PROBLEM

As a result of earnest investigation as to the problem described above, the present inventors have found that the problem described above can be solved by an Al bonding wire or an Al bonding ribbon containing 3.0 % by mass or more and 20.0 % by mass or less of Si, wherein, when a crystal orientation of an Al phase in an L cross-section (cross section in a center axis direction including a center axis) of the Al bonding wire or the Al bonding ribbon is measured, an orientation ratio of a <110> crystal orientation angled at 15° or less to a direction perpendicular to the center axis (ND direction) is equal to or larger than 10% and equal to or smaller than 40%, and an orientation ratio of a <100> crystal orientation angled at 15° or less to a direction parallel to the center axis (RD direction) is equal to or larger than 15% and equal to or smaller than 50%, and further investigated the problem based on such knowledge to complete the present invention.

That is, the present invention includes the following content.

<1> An Al bonding wire or an Al bonding ribbon containing 3.0 % by mass or more and 20.0 % by mass or less of Si, wherein
when a crystal orientation of an Al phase in an L cross-section (cross section in a center axis direction including a

center axis) of the Al bonding wire or the Al bonding ribbon is measured, an orientation ratio of a <110> crystal orientation angled at 15° or less to a direction perpendicular to the center axis (ND direction) is equal to or larger than 10% and equal to or smaller than 40%, and an orientation ratio of a <100> crystal orientation angled at 15° or less to a direction parallel to the center axis (RD direction) is equal to or larger than 15% and equal to or smaller than 50%.

<2> The Al bonding wire or the Al bonding ribbon according to <1>, wherein an average diameter of the Al phase in the L cross-section is equal to or larger than 5.0 μm and equal to or smaller than 40.0 μm.

<3> The Al bonding wire or the Al bonding ribbon according to <1> or <2>, wherein an average diameter of a Si phase in the L cross-section is equal to or larger than 0.8 μm and equal to or smaller than 4.0 μm.

<4> The Al bonding wire or the Al bonding ribbon according to any one of <1> to <3>, further containing 10 mass ppm or more and 800 mass ppm or less of one or more of Sr, Na, Ni, and B in total.

<5> The Al bonding wire or the Al bonding ribbon according to any one of <1> to <4>, further containing 100 mass ppm or more and 2000 mass ppm or less of one or more of Mn, Ti, Fe, Cu, and Mg in total.

<6> The Al bonding wire or the Al bonding ribbon according to any one of <1> to <5>, wherein a total concentration of elements other than Al, Si, Sr, Na, Ni, B, Mn, Ti, Fe, Cu, and Mg in the Al bonding wire or the Al bonding ribbon is equal to or smaller than 0.5 % by mass.

<7> The Al bonding wire or the Al bonding ribbon according to any one of <1> to <6>, wherein the orientation ratios of the crystal orientations are values measured by using a SEM-EDS-EBSD apparatus.

<8> The Al bonding wire or the Al bonding ribbon according to any one of <2> to <7>, wherein the average diameter is a value measured by using a SEM-EDS-EBSD apparatus.

<9> The Al bonding wire or the Al bonding ribbon according to any one of <1> to <8>, used for a semiconductor device.

<10> A semiconductor device comprising the Al bonding wire or the Al bonding ribbon according to any one of <1> to <9>.

## EFFECT OF THE INVENTION

According to the present invention, it is possible to provide an Al bonding wire or an Al bonding ribbon that exhibits excellent temperature cycle reliability even in a temperature cycle test having a large number of cycles, which is required for next-generation SiC power semiconductors, and a semiconductor device obtained by using the Al bonding wire or the Al bonding ribbon.

## BRIEF DESCRIPTION OF DRAWINGS

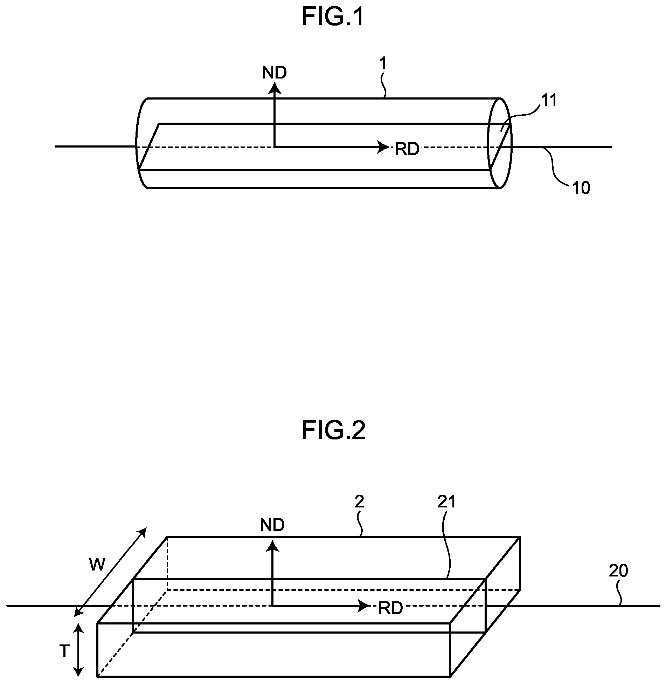

FIG. 1 is a schematic diagram for explaining, regarding an Al bonding wire, a measurement target surface (inspection surface) when measuring a crystal orientation of an Al phase, an average diameter of the Al phase, and an average diameter of a Si phase. FIG. 1 is also a schematic diagram for explaining, regarding the Al bonding wire, an RD direction and an ND direction. The measurement target surface is a cross section in a center axis direction including a center axis (L cross-section) of the Al bonding wire.

FIG. 2 is a schematic diagram for explaining, regarding an Al bonding ribbon, a measurement target surface (inspection surface) when measuring a crystal orientation of an Al phase, an average diameter of the Al phase, and an average diameter of a Si phase. FIG. 2 is also a schematic diagram for explaining, regarding the Al bonding ribbon, an RD direction and an ND direction. The measurement target surface is a cross section in a center axis direction including a center axis (L cross-section) of the Al bonding ribbon.

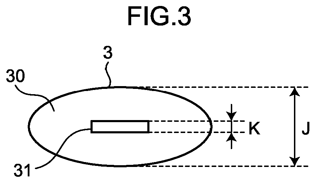

FIG. 3 is a schematic diagram for explaining a hollow defect of a 1st bonding part regarding the Al bonding wire.

## EMBODIMENT FOR CARRYING OUT THE INVENTION

Hereinafter, the present invention will be described in detail with reference to preferable embodiments thereof. While the drawings may be referred to for description, each of the drawings merely schematically illustrates shapes, sizes, and arrangement of constituent elements to the extent that the invention can be understood. The present invention is not limited to the following embodiments and examples, and may be optionally changed to be implemented without departing from CLAIMS of the present invention and equivalents thereof.

[Al bonding wire or Al bonding ribbon]

The Al bonding wire or the Al bonding ribbon according to the present invention is an Al bonding wire or an Al bonding ribbon containing 3.0 % by mass or more and 20.0 % by mass or less of Si, wherein,

when a crystal orientation of an Al phase in an L cross-section (cross section in a center axis direction including a center axis) of the Al bonding wire or the Al bonding ribbon is measured, an orientation ratio of a <110> crystal orientation angled at 15° or less to a direction perpendicular to the center axis (ND direction, Normal Direction) (hereinafter, also referred to as an "orientation ratio of the <110> crystal orientation of the Al phase in the ND direction") is equal to or larger than 10% and equal to or smaller than 40%, and an orientation ratio of a <100> crystal orientation angled at 15° or less to a direction parallel to the center axis (RD direction, Rolling Direction) (hereinafter, also referred to as an "orientation ratio of the <100> crystal orientation of the Al phase in the RD direction") is equal to or larger than 15% and equal to or smaller than 50%.

As described above, in a case of using a connection material composed only of high-purity Al in a temperature cycle test, there is a problem in that a crack develops at a relatively high speed inside the connection material, and temperature cycle reliability is lowered. It has been confirmed that, in an Al alloy to which Si is added at a high concentration, thermal expansion of the connection material can be reduced, and temperature cycle reliability can be improved. On the other hand, even in a case of using an Al alloy to which Si is added at a high concentration, bonding strength may be lowered when the number of cycles of the temperature cycle test considerably increases, and further improvement in temperature cycle reliability is necessary to satisfy temperature cycle reliability required for a next-generation power semiconductor device having high heat resistance, such as SiC.

Herein, the present inventors have clarified that, due to an increase in the number of cycles in the temperature cycle test, a failure occurrence mode and a failure occurrence factor change at a bonding part of a wire or a ribbon. Although it varies depending on detailed conditions of a temperature history, crack development inside a wire or a ribbon is dominant up to about 1000 temperature cycles, whereas when the number of temperature cycles exceeds 1500 cycles, crack development at two locations, that is, inside the wire or the ribbon and inside an electrode, occurs in a combined manner, thereby lowering temperature cycle reliability. When the number of temperature cycles reaches 2000 cycles, it is insufficient to merely reduce cracks at only one of the locations, and it is effective to achieve suppression of cracks inside the Al bonding wire or the Al bonding ribbon and suppression of cracks inside the electrode at the same time.

As a result of earnest investigation as to the problem described above, the present inventors have found that, in an Al bonding wire or an Al bonding ribbon containing 3.0% by mass or more and 20.0% by mass or less of Si, by adjusting the orientation ratio of the <110> crystal orientation of the Al phase in a direction perpendicular to the center axis (ND direction) in the L cross-section and the orientation ratio of the <100> crystal orientation of the Al phase in a direction parallel to the center axis (RD direction) at the same time, temperature cycle reliability can be improved even in a temperature cycle test with a considerably large number of temperature cycles, thereby contributing to a longer lifetime of the Al bonding wire or the Al bonding ribbon. That is, with respect to structures in different directions of the Al bonding wire or the Al bonding ribbon, by mutually controlling different crystal orientations of the Al phase, temperature cycle reliability can be improved even in a severe temperature cycle test.

The Al bonding wire or the Al bonding ribbon according to the present invention contains 3.0% by mass or more and 20.0% by mass or less of Si, and includes the Al phase in which Si is dissolved in Al as a solid solution and a Si phase formed by crystallization or precipitation of Si. In the Al phase, other additive elements may be dissolved as a solid solution in addition to Si. The Si phase is a general term for Si crystallized products and Si precipitates. The Si crystallized product is formed from a solution during solidification, and has a size of about 1 to 25 μm, which is coarse. On the other hand, the Si precipitate is formed from a solid state, and has a small size of about 0.1 μm to several micrometers.

In the present invention, a "wire" and a "ribbon" are classified not by a shape but by a manufacturing method thereof. That is, the term "wire" refers to "a connection material manufactured by wire-drawing processing using a die", and the term "ribbon" refers to "a connection material manufactured by a rolling process". A "wire" usually has a circular cross-sectional shape, and a "ribbon" usually has a rectangular or substantially rectangular cross-sectional shape.

In the present invention, the term "ND direction" refers to a direction that satisfies both "a direction perpendicular to the center axis" and "a direction perpendicular to a rolling surface". In a case of a wire, since force is applied from all directions in wire-drawing processing using a die, there is arbitrariness in how the ND direction is defined, and there is also arbitrariness in how the L cross-section (a cross section in the center axis direction including the center axis) is defined; however, it is common to define the L cross-section and the ND direction to be perpendicular to each other, and such a definition is also adopted in the present invention. In a case of a ribbon, the "ND direction" is uniquely determined by definition of "a direction perpendicular to the rolling surface". On the other hand, in a case of a ribbon, the L cross-section can be defined in two ways: "a cross section perpendicular to a width W direction" and "a cross section perpendicular to a thickness T direction". For ease of cross-sectional polishing and EBSD analysis, the L cross-section is defined as the "cross section perpendicular to the width W direction"(FIG. 2).

That is, regarding the Al bonding wire, the center axis, the cross section in the center axis direction including the center axis (L cross-section), the RD direction, and the ND direction are as illustrated in FIG. 1. FIG. 1 illustrates a case of the Al bonding wire having a circular cross-sectional shape. In a case of the Al bonding ribbon having a rectangular or substantially rectangular cross-sectional shape with a width W and a thickness T, the center axis indicates an axis passing through the center of the width W and the center of the thickness T, and the L cross-section indicates a cross section in the center axis direction including the center axis and perpendicular to the width W direction (FIG. 2). Specifically, regarding

the Al bonding ribbon, the center axis, the cross section in the center axis direction including the center axis (L cross-section), the RD direction, and the ND direction are as illustrated in FIG. 2. Herein, when cross-sectional processing is performed to expose the L cross-section of the Al bonding wire, it may be deviated from the center axis of the Al bonding wire. At this point, if the length of the L cross-section in the direction perpendicular to the center axis is 90% or more of a wire diameter of the Al bonding wire, the cross section can be regarded as a cross section including the center axis.

A reason why the Al bonding wire or the Al bonding ribbon according to the present invention can exhibit excellent temperature cycle reliability even in a temperature cycle test with a large number of cycles is estimated as follows.

The Si phase has a smaller coefficient of linear thermal expansion than that of Al, contributes to reduction of a difference in coefficient of linear thermal expansion between the Al bonding wire or the Al bonding ribbon and the semiconductor chip, and is therefore considered to be capable of reducing generated thermal stress. It is also considered that a particulate Si phase may suppress growth of a crack generated at a bonding interface into an inner part of the Al bonding wire or the Al bonding ribbon.

Up to about 1000 cycles of the temperature cycle test, it is effective to utilize an effect of the Si phase to lower a coefficient of linear thermal expansion and to adjust a crystal orientation of the Al bonding wire or the Al bonding ribbon that enhances the effect. On the other hand, when the number of temperature cycles increases to exceed 1500 cycles, recovery and recrystallization of the Al phase proceed in both the Al bonding wire or the Al bonding ribbon itself and the electrode serving as a bonding counterpart, whereby an influence of thermal distortion on a crack changes. Therefore, in a bonding part that can withstand 2000 cycles, it is considered that suitable conditions of crystal orientations of the Al phase that respectively influence a crack inside the Al bonding wire or the Al bonding ribbon and a crack inside the electrode change.

Although the present invention is characterized in that crystal orientations in the ND direction and the RD direction mutually relate to each other to enhance effects, these effects will be separately described intentionally. When the <110> crystal orientation of the Al phase in the ND direction falls within a range equal to or larger than 10% and equal to or smaller than 40%, it is possible to enhance a role of preventing a crack from developing, branching and/or expanding inside the wire or the ribbon. In addition, when the orientation ratio of the <100> crystal orientation of the Al phase in the RD direction falls within a range equal to or larger than 15% and equal to or smaller than 50%, it is possible to relieve an increase in stress inside the Al bonding wire or the Al bonding ribbon in the temperature cycle test, and it is considered that there is an effect of suppressing crack development inside the electrode.

That is, by combining an effect of reducing cracks in a wire internal direction by controlling the <110> crystal orientation of the Al phase in the ND direction and an effect of mainly reducing crack growth inside the electrode by controlling the <100> crystal orientation of the Al phase in the RD direction, it is possible to extend a time to occurrence of failure in the bonding part even in a severe test in which the number of cycles of the temperature cycle test is 2000 cycles. When this factor is explained by dividing it in accordance with a vector direction of thermal distortion, it is considered that an influence of the <110> crystal orientation of the Al phase in the ND direction has a function of reducing a component force in a radial direction (center direction) from the bonding interface, and that an influence of the <100> crystal orientation of the Al phase in the RD direction acts on a component force in a wire longitudinal direction. Control of the <110> crystal orientation of the Al phase in the ND direction alone has an effect of suppressing crack development inside the electrode, and control of the <100> crystal orientation of the Al phase in the RD direction alone has an effect of suppressing cracks inside the wire or the ribbon; however, by simultaneously controlling both of these crystal orientations, a synergistic effect can be enhanced.

As described above, it is estimated that the Al bonding wire or the Al bonding ribbon of the present invention can provide excellent temperature cycle reliability as previously mentioned, as a result of appropriate control of factors contributing to improvement in temperature cycle reliability in a considerably long temperature cycle test of about 2000 cycles.

-Si concentration-

A Si concentration in a range equal to or larger than 3.0% by mass and equal to or smaller than 20.0% by mass is useful in reducing thermal distortion of the bonding part and improving temperature cycle reliability. Specifically, when the Si concentration is equal to or larger than 3.0% by mass, an improvement effect in temperature cycle reliability can be increased. In addition, regarding an upper limit of the Si concentration, along with progress and optimization of equipment and conditions used for manufacturing and bonding of a wire or the like, higher values have become allowable while suppressing defects such as wire breakage during processing, deterioration of surface properties, reduction in initial bonding strength due to hardening, and damage to the semiconductor chip; however, when the Si concentration is equal to or smaller than 20.0% by mass, these defects can be favorably suppressed while achieving intended temperature cycle reliability. From a viewpoint of obtaining favorable temperature cycle reliability, the concentration of Si in the Al bonding wire or the Al bonding ribbon according to the present invention is equal to or larger than 3.0% by mass, preferably equal to or larger than 3.5% by mass, more preferably equal to or larger than 4.0% by mass, even more preferably equal to or larger

than 4.2% by mass, equal to or larger than 4.4% by mass, equal to or larger than 4.5% by mass, equal to or larger than 4.6% by mass, equal to or larger than 4.8% by mass, or equal to or larger than 5.0% by mass. In addition, from a viewpoint of achieving intended temperature cycle reliability while favorably suppressing defects such as reduction in initial bonding strength due to hardening and damage to the semiconductor chip, the concentration of Si in the Al bonding wire or the Al bonding ribbon according to the present invention is equal to or smaller than 20.0% by mass, and preferably equal to or smaller than 19.0% by mass, equal to or smaller than 18.0% by mass, equal to or smaller than 17.0% by mass, equal to or smaller than 16.0% by mass, equal to or smaller than 15.0% by mass, equal to or smaller than 14.5% by mass, equal to or smaller than 14.0% by mass, equal to or smaller than 13.5% by mass, equal to or smaller than 13.0% by mass, or equal to or smaller than 12.5% by mass. Furthermore, when hardness of the Al bonding wire or the Al bonding ribbon is high, the semiconductor chip tends to be easily damaged at the time of 1st bonding depending on bonding conditions of ultrasonic vibrations and loads. From a viewpoint of obtaining favorable bonding strength under a wider range of bonding conditions, the Si concentration in the Al bonding wire or the Al bonding ribbon according to the present invention is more preferably equal to or smaller than 12.0% by mass, still more preferably equal to or smaller than 11.5% by mass or equal to or smaller than 11.0% by mass, and particularly preferably equal to or smaller than 10.8% by mass, equal to or smaller than 10.6% by mass, equal to or smaller than 10.5% by mass, equal to or smaller than 10.4% by mass, equal to or smaller than 10.2% by mass, or equal to or smaller than 10.0% by mass.

For concentration analysis of elements contained in the Al bonding wire or the Al bonding ribbon according to the present invention, for example, an Inductively Coupled Plasma (ICP) emission spectrophotometer or an ICP mass spectrometer can be used. In a case in which elements derived from contaminants in the air, such as oxygen and/or carbon, are adsorbed on a surface of the Al bonding wire or the Al bonding ribbon, it is effective to clean it with acid and/or alkali depending on adsorbed substances before performing analysis.

-Crystal orientation of Al phase in L cross-section-

From a viewpoint of obtaining excellent temperature cycle reliability even in the temperature cycle test with a large number of cycles, when a crystal orientation of the Al phase in the L cross-section of the Al bonding wire or the Al bonding ribbon is measured, an orientation ratio of the <100> crystal orientation angled at 15° or less to a direction parallel to the center axis (RD direction) is equal to or larger than 15%, preferably equal to or larger than 20%, more preferably equal to or larger than 22%, equal to or larger than 24%, equal to or larger than 26%, or equal to or larger than 28%, still more preferably equal to or larger than 30%, and even more preferably equal to or larger than 35%. From a viewpoint of obtaining excellent temperature cycle reliability in the temperature cycle test with a larger number of cycles, an upper limit of the orientation ratio of the <100> crystal orientation of the Al phase in the RD direction is equal to or smaller than 50%, preferably equal to or smaller than 48% or equal to or smaller than 45%, more preferably equal to or smaller than 42%, and still more preferably equal to or smaller than 40%.

From a viewpoint of obtaining excellent temperature cycle reliability even in the temperature cycle test with a large number of cycles, when the crystal orientation of the Al phase in the L cross-section of the Al bonding wire or the Al bonding ribbon is measured, an orientation ratio of the <110> crystal orientation angled at 15° or less to a direction perpendicular to the center axis (ND direction) is equal to or larger than 10%, preferably equal to or larger than 15%, more preferably equal to or larger than 18%, and still more preferably equal to or larger than 20%. From a viewpoint of obtaining excellent temperature cycle reliability in the temperature cycle test with a larger number of cycles, an upper limit of the orientation ratio of the <110> crystal orientation of the Al phase in the ND direction is equal to or smaller than 40%, preferably equal to or smaller than 38% or equal to or smaller than 36%, more preferably equal to or smaller than 34% or equal to or smaller than 32%, and still more preferably equal to or smaller than 30%.

Herein, by setting the orientation ratio of the <100> crystal orientation of the Al phase in the RD direction to be equal to or larger than 15%, a length of a crack inside the electrode rapidly decreases in the temperature cycle test with a large number of cycles. In addition, by setting the orientation ratio of the <100> crystal orientation of the Al phase in the RD direction to be equal to or smaller than 50%, it is possible to obtain very favorable metallic bonding with the electrode at the time of bonding. Due to the above two factors, in a case in which the orientation ratio of the <100> crystal orientation of the Al phase in the RD direction is set to be equal to or larger than 15% and equal to or smaller than 50%, a decrease in bonding strength after 2000 cycles in the temperature cycle test is significantly suppressed.

On the other hand, by setting the orientation ratio of the <110> crystal orientation of the Al phase in the ND direction to be equal to or larger than 10%, an effect of suppressing crack development inside the wire is significantly improved in the temperature cycle test with a large number of cycles. By setting the orientation ratio of the <110> crystal orientation of the Al phase in the ND direction to be equal to or smaller than 40%, variation in a deformed shape of the wire or the ribbon can be significantly suppressed, and ultrasonic bonding becomes stable. As a result, in a case in which the orientation ratio of the <110> crystal orientation of the Al phase in the ND direction is set to be equal to or larger than 10% and equal to or smaller than 40%, a decrease in bonding strength after 2000 cycles is significantly suppressed in the temperature cycle test.

The orientation ratio of the crystal orientation of the Al phase in the L cross-section of the Al bonding wire or the Al bonding ribbon can be measured by using a SEM-EDS-EBSD apparatus. Specifically, a method of combining information of Al concentration and Si concentration obtained by Scanning Electron Microscope-Energy Dispersive X-ray Spectroscopy (SEM-EDS) and information of a crystal orientation obtained by Electron BackScatter Diffraction (EBSD) can be used. More specifically, in a measurement region designating the L cross-section of the Al bonding wire or the Al bonding ribbon to be an inspection surface, measurement of concentration of Al and Si using the EDS and crystal orientation analysis using the EBSD are performed at the same time. Subsequently, the Al phase and the Si phase are separated and extracted from a measurement result of the EDS by using analysis software attached to the apparatus. Specifically, it is preferable to use Chi Scan function, which is a function of analysis software OIM Data Collection or OIM Analysis (both manufactured by TSL solutions KK) attached to a Field Emission-Scanning Electron Microscope (FE-SEM) apparatus. For a region specified as the Al phase, orientation ratios of the <100> crystal orientation of the Al phase in the RD direction and the <110> crystal orientation of the Al phase in the ND direction can be respectively calculated by using the analysis software attached to the apparatus. In calculating the orientation ratio, a partial ratio is used, the partial ratio being calculated by using, as a population, an area of only crystal orientations that have been identified based on certain reliability within a measurement area. Regarding the crystal orientation of the Al phase, the orientation ratio of the <100> crystal orientation in the RD direction and the orientation ratio of the <110> crystal orientation in the ND direction are respectively defined as an area ratio of the <100> crystal orientation in the RD direction and an area ratio of the <110> crystal orientation in the ND direction. Thus, in one embodiment, the orientation ratio of the crystal orientation of the Al phase in the L cross-section of the Al bonding wire or the Al bonding ribbon according to the present invention is calculated through procedures from (1) to (3) as follows.

(1) In the measurement region designating the L cross-section of the Al bonding wire or the Al bonding ribbon to be the inspection surface, measurement of concentration of Al and Si using the EDS and crystal orientation measurement using the EBSD are performed at the same time.
(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.
(3) For the region that is specified as the Al phase, the crystal orientations are analyzed, and the orientation ratio of the <100> crystal orientation of the Al phase in the RD direction and the orientation ratio of the <110> crystal orientation of the Al phase in the ND direction are calculated.

In the procedure of (2) described above, setting of Tolerance (%) can be selected in a range from 20 to 40%, and about 30% is preferable for comparison in standard analysis of the L cross-section of the Al bonding wire or the Al bonding ribbon. The following supplementarily describes a procedure of adjusting the Tolerance. It is preferable to select or confirm a numerical value of Tolerance so that the shape and the size of the Si phase extracted and identified by the Chi Scan function are equivalent to the shape and the size of the Si phase identified from an EDS map in which Si element concentration by EDS analysis is two-dimensionally displayed.

In the present invention, the orientation ratio of the <100> crystal orientation of the Al phase in the RD direction and the orientation ratio of the <110> crystal orientation of the Al phase in the ND direction in the L cross-section are calculated as average values (arithmetic means) of respective values of the orientation ratios obtained by measuring at three or more parts. In selecting the measurement region, from a viewpoint of securing objectivity of measurement data, it is preferable to acquire a sample for measurement to be measured from the Al bonding wire or the Al bonding ribbon as a measurement target at intervals of 50 cm or more with respect to the center axis direction of the Al bonding wire or the Al bonding ribbon. In the present invention, the measurement region for the crystal orientation in the L cross-section measured by the EBSD method is preferably determined so that the length in the center axis direction of the Al bonding wire or the Al bonding ribbon is equal to or larger than 300 $\mu$m and smaller than 800 $\mu$m, and the entire Al bonding wire or the entire Al bonding ribbon is accommodated therein in a direction perpendicular to the center axis of the Al bonding wire or the Al bonding ribbon, but if the size is large and the entire region is difficult to be measured, it can be adjusted in a range smaller than 600 $\mu$m.

-Average diameter of Al phase in L cross-section-

In the Al bonding wire or the Al bonding ribbon according to the present invention, an average diameter of the Al phase in the L cross-section is preferably equal to or larger than 5.0 $\mu$m and equal to or smaller than 40.0 $\mu$m.

The present inventors have found that, when the average diameter of the Al phase in the L cross-section falls within a range equal to or larger than 5.0 $\mu$m and equal to or smaller than 40.0 $\mu$m, there is an effect of stably maintaining shear force of the bonding part at a high level after 2000 cycles in the temperature cycle test. A reason for this is considered to be a synergistic effect of reducing thermal distortion by containing Si at a predetermined concentration and controlling

the orientation ratio of the crystal orientation of the Al phase to fall within a predetermined range, and a structure in which the average diameter of the Al phase is adjusted to be equal to or larger than 5.0 μm and equal to or smaller than 40.0 μm. By way of example of the effect of this action, the shear force of the bonding part after 2000 cycles can be increased by 10% or more. Regarding specific influence of the average diameter of the Al phase, in ultrasonic bonding (wedge bonding) of the Al bonding wire or the Al bonding ribbon containing a large amount of the Si phases, it is estimated that temperature cycle reliability is stably enhanced by efficient action of, for example, ease of obtaining favorable metallic bonding by mutual deformation of the Al bonding wire or the Al bonding ribbon and the electrode, and stabilization of growth of recrystallized grains during the temperature cycle test to relieve thermal stress at the bonding interface.

From a viewpoint of suppressing variation in bonding strength in the temperature cycle test with a large number of cycles, the average diameter of the Al phase in the L cross-section is preferably equal to or larger than 5.0 μm, more preferably equal to or larger than 8.0 μm, still more preferably equal to or larger than 10.0 μm, and particularly preferably equal to or larger than 12.0 μm or equal to or larger than 15.0 μm. From a viewpoint of suppressing variation in bonding strength in the temperature cycle test with a large number of cycles, an upper limit of the average diameter of the Al phase in the L cross-section is preferably equal to or smaller than 40.0 μm, more preferably equal to or smaller than 38.0 μm or equal to or smaller than 35.0 μm, still more preferably equal to or smaller than 32.0 μm or equal to or smaller than 30.0 μm, and particularly preferably equal to or smaller than 28.0 μm or equal to or smaller than 25.0 μm.

By setting the average diameter of the Al phase in the L cross-section to be equal to or larger than 5.0 μm, deformation of the electrode during ultrasonic bonding can be significantly suppressed. By setting the average diameter of the Al phase to be equal to or smaller than 40.0 μm, a bonding shape of the wire or the ribbon can be significantly stabilized. Due to these factors, it is considered that, by setting the average diameter of the Al phase in the L cross-section to be equal to or larger than 5.0 μm and equal to or smaller than 40.0 μm, it is possible to significantly reduce variation in shear force of the bonding part after the temperature cycle test with a large number of cycles.

The following describes a method for measuring the average diameter of the Al phase in the L cross-section of the Al bonding wire or the Al bonding ribbon. The average diameter of the Al phase in the L cross-section can be measured by using the SEM-EDS-EBSD apparatus similarly to measurement of the orientation ratio of the crystal orientation described above. Specifically, a method of combining information of Al concentration and Si concentration obtained by the SEM-EDS and information of a crystal orientation obtained by the EBSD can be used. A more specific procedure is the same as that described above in relation to measurement of the orientation ratio of the crystal orientation, that is, the crystal orientation can be analyzed for a region specified as the Al phase by using the analysis software attached to the apparatus. If an orientation difference between measurement points is equal to or larger than 15°, it is determined to be a crystal grain boundary, and an equivalent circle diameter is calculated. The average diameter of the Al phase is defined as an average value of the equivalent circle diameters of respective Al phases. In a process of obtaining the average diameter of the Al phase, calculation is performed excluding a part in which the crystal orientation cannot be measured, and a part in which the crystal orientation can be measured but reliability of orientation analysis is low. Thus, in one embodiment, the average diameter of the Al phase in the L cross-section of the Al bonding wire or the Al bonding ribbon according to the present invention is calculated through procedures from (1) to (3) as follows.

(1) The L cross-section of the Al bonding wire or the Al bonding ribbon is designated as the inspection surface, and measurement of concentration of Al and Si using the EDS and crystal orientation measurement using the EBSD are performed at the same time.

(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.

(3) For the region that is specified as the Al phase, the crystal orientation is analyzed, and if the orientation difference between measurement points is equal to or larger than 15°, it is determined to be the crystal grain boundary, and the equivalent circle diameter of each crystal grain is obtained. An average of equivalent circle diameters of the respective crystal grains is calculated to obtain the average diameter of the Al phase. Herein, regarding average calculation, an average value obtained by Area average (area-weighted average), which can be selected by the software attached to the apparatus, is employed. By employing the average value obtained by Area average, it is possible to accurately measure and determine whether a condition is met, the condition being related to the average diameter of the Al phase and suitable for suppressing variation in bonding strength in the temperature cycle test with a large number of cycles. In the calculation of Area average, the average value is calculated from an average of values obtained by multiplying a ratio of an area of each particle to areas of all particles by an area value of each particle, which is automatically computed by software.

In the present invention, in calculating the average diameter of the Al phase in the L cross-section, only Al phases having a diameter (equivalent circle diameter) equal to or larger than 0.5 μm are considered as targets. Due to this, it is possible to accurately determine whether a requirement is met, the requirement being related to the average diameter of

the Al phase in the L cross-section and suitable for stably maintaining the shear force of the bonding part at a high level after 2000 cycles in the temperature cycle test.

In measuring the average diameter of the Al phase in the L cross-section, a setting range of Tolerance in the procedure of (2) described above, a method of acquiring a sample for measurement, and a measurement region of crystal orientation by the EBSD method are the same as those described above regarding measurement of the orientation ratio of the crystal orientation of the Al phase.

-Average diameter of Si phase in L cross-section-

In the Al bonding wire or the Al bonding ribbon according to the present invention, an average diameter of the Si phase in the L cross-section is preferably equal to or larger than 0.8 μm and equal to or smaller than 4.0 μm.

Regarding the Al bonding wire or the Al bonding ribbon that is highly strengthened by adding Si and the like thereto, the semiconductor chip tends to be damaged at the time of 1st bonding, and if ultrasonic vibrations and loads are adjusted to reduce such damage, a phenomenon in which a part with insufficient metallic bonding is formed in the vicinity of the center of a bonding region of the Al bonding wire or the Al bonding ribbon and the electrode (hereinafter, also referred to as a "hollow") may be caused. The portion where the hollow is generated becomes a starting point where bonding strength is lowered or a fault is caused in the temperature cycle test because metallic bonding is insufficient.

When the average diameter of the Si phase in the L cross-section falls within a range equal to or larger than 0.8 μm and equal to or smaller than 4.0 μm, a hollow at a 1st bonding part can be suppressed. It is considered that an effect of accelerating deformation of the Al phase contributing to bonding, or enhancing transmission efficiency of ultrasonic vibrations to a center part of the bonding region is obtained by controlling the average diameter of the Si phase, and the hollow can be suppressed.

From a viewpoint of further suppressing a hollow at the 1st bonding part, the average diameter of the Si phase in the L cross-section of the Al bonding wire or the Al bonding ribbon according to the present invention is more preferably equal to or smaller than 3.8 μm or equal to or smaller than 3.5 μm, and still more preferably equal to or smaller than 3.4 μm, equal to or smaller than 3.2 μm, or equal to or smaller than 3.0 μm, and a lower limit thereof is more preferably equal to or larger than 1.0 μm or equal to or larger than 1.1 μm, and still more preferably equal to or larger than 1.2 μm or equal to or larger than 1.5 μm.

The following describes a method for measuring the average diameter of the Si phase in the L cross-section of the Al bonding wire or the Al bonding ribbon. The average diameter of the Si phase in the L cross-section can be measured by using the SEM-EDS-EBSD apparatus similarly to measurement of the orientation ratio of the crystal orientation of the Al phase described above. Specifically, a method of combining information of Al concentration and Si concentration obtained by the SEM-EDS and information of a crystal orientation obtained by the EBSD can be used. A more specific procedure is the same as that described above in relation to measurement of the orientation ratio of the crystal orientation of the Al phase, that is, the crystal orientation can be analyzed for a region specified as the Si phase by using the analysis software attached to the apparatus. If an orientation difference between measurement points is equal to or larger than 15°, it is determined to be a crystal grain boundary, and an equivalent circle diameter is calculated. The average diameter of the Si phase is defined as an average value of the equivalent circle diameters of respective Si phases. In a process of obtaining the average diameter of the Si phase, calculation is performed excluding a part in which the crystal orientation cannot be measured, and a part in which the crystal orientation can be measured but reliability of orientation analysis is low. Thus, in one embodiment, the average diameter of the Si phase in the L cross-section of the Al bonding wire or the Al bonding ribbon according to the present invention is calculated through procedures from (1) to (3) as follows.

(1) The L cross-section of the Al bonding wire or the Al bonding ribbon is designated as the inspection surface, and measurement of concentration of Al and Si using the EDS and crystal orientation measurement using the EBSD are performed at the same time.

(2) Al and Si are separated and extracted by using the Chi Scan function. Specifically, Al and Si can be separated and identified by setting Tolerance corresponding to a threshold of Si based on a measurement result of the EDS for Si. The crystal orientation can be analyzed by using the crystal information of Al and Si in a material file.

(3) For the region that is specified as the Si phase, the crystal orientation is analyzed, and if the orientation difference between measurement points is equal to or larger than 15°, it is determined to be the crystal grain boundary, and the equivalent circle diameter of each crystal grain is obtained. An average of equivalent circle diameters of the respective crystal grains is calculated to obtain the average diameter of the Si phase. Herein, regarding average calculation, an average value obtained by Area average (area-weighted average), which can be selected by the software attached to the apparatus, is employed. By employing the average value obtained by Area average, it is possible to accurately measure and determine whether a condition is met, the condition being related to the average diameter of the Si phase and suitable for suppressing a hollow at the 1st bonding part. In the calculation of Area average, the average value is calculated from an average of values obtained by multiplying a ratio of an area of each particle to areas of all particles

by an area value of each particle, which is automatically computed by software.

In the present invention, in calculating the average diameter of the Si phase in the L cross-section, only Si phases having a diameter (equivalent circle diameter) equal to or larger than 0.5 μm are considered as targets. Due to this, it is possible to accurately determine whether a requirement is met, the requirement being related to the average diameter of the Si phase in the L cross-section and suitable for suppressing a hollow at the 1st bonding part.

In measuring the average diameter of the Si phase in the L cross-section, a setting range of Tolerance in the procedure of (2) described above, a method of acquiring a sample for measurement, and a measurement region of crystal orientation by the EBSD method are the same as those described above regarding measurement of the orientation ratio of the crystal orientation of the Al phase.

Examples of the method for measuring the average diameter of the Si phase include several methods including binarization processing from an observation image of the L cross-section in addition to the methods described above. The present invention preferably uses the method of combining information of Al concentration and Si concentration obtained by the SEM-EDS and information of crystal orientation obtained by the EBSD as described above because many measuring functions are provided and a plurality of characteristics such as the orientation ratio of the crystal orientation of the Al phase, the average diameter of the Al phase, and the average diameter of the Si phase described above can be obtained by one time of measurement, automatic analysis can be performed, and measurement can be easily performed with a widespread apparatus and analysis technique.

-Addition of Sr, Na, Ni, and B-

The Al bonding wire or the Al bonding ribbon according to the present invention may further contain one or more of Sr, Na, Ni, and B (hereinafter, also referred to as a "first element group"). A total concentration of the first element group may be 0 mass ppm, preferably equal to or larger than 1 mass ppm, more preferably equal to or larger than 3 mass ppm, still more preferably equal to or larger than 5 mass ppm, and particularly preferably equal to or larger than 8 mass ppm or equal to or larger than 10 mass ppm. An upper limit of the total concentration of the first element group is preferably equal to or smaller than 10000 mass ppm or equal to or smaller than 8000 mass ppm, more preferably equal to or smaller than 5000 mass ppm or equal to or smaller than 3000 mass ppm, still more preferably equal to or smaller than 2000 mass ppm or equal to or smaller than 1000 mass ppm, and particularly preferably equal to or smaller than 900 mass ppm or equal to or smaller than 800 mass ppm. In one embodiment, the total concentration of the first element group is preferably equal to or larger than 10 mass ppm and equal to or smaller than 800 mass ppm.

When the Al bonding wire or the Al bonding ribbon according to the present invention further contains 10 mass ppm or more and 800 mass ppm or less of one or more of Sr, Na, Ni, and B in total, a generation frequency of wire breakage can be reduced in wire-drawing processing for the Al bonding wire or the Al bonding ribbon. In an Al alloy containing a high concentration of Si equal to or larger than 3.0% by mass and equal to or smaller than 20.0% by mass, a frequency of wire breakage at a wire-drawing step tends to be increased. This may be because particles of the Si phase crystallized at the time of solidification cause stress concentration during the wire-drawing processing, and induce wire breakage. It is estimated that stress concentration during wire-drawing can be relieved and wire breakage can be reduced due to effects such that the particulate Si phase may be uniformly distributed and/or growth and coarsening of the Si phase may be suppressed by adding the first element group. It is considered that an effect of relieving stress concentration during wire-drawing can be enhanced by controlling the orientation ratio of the crystal orientation of the Al phase in the ND direction and the orientation ratio of the crystal orientation of the Al phase in the RD direction in the L cross-section and adding the first element group thereto.

From a viewpoint of reducing the generation frequency of wire breakage in the wire-drawing processing, the total concentration of the first element group in the Al bonding wire or the Al bonding ribbon according to the present invention is more preferably equal to or larger than 20 mass ppm, and still more preferably equal to or larger than 30 mass ppm, equal to or larger than 40 mass ppm, or equal to or larger than 50 mass ppm, and an upper limit thereof is preferably equal to or smaller than 750 mass ppm, more preferably equal to or smaller than 740 mass ppm, equal to or smaller than 720 mass ppm, or equal to or smaller than 700 mass ppm, still more preferably equal to or smaller than 680 mass ppm, equal to or smaller than 650 mass ppm, equal to or smaller than 620 mass ppm, or equal to or smaller than 600 mass ppm, and particularly preferably equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains one or more elements of the first element group, it may contain any one element of the first element group, may contain any two elements of the first element group, may contain any three elements of the first element group, or may contain all of four elements of the first element group. In a case in which the Al bonding wire or the Al bonding ribbon according to the present invention contains one or more elements of the first element group, it may contain Sr, may contain Na, may contain Ni, and/or may contain B.

In a case in which the Al bonding wire or the Al bonding ribbon according to the present invention contains Sr of the first element group, a concentration of Sr may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Sr is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Sr is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Sr is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Na of the first element group, a concentration of Na may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Na is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Na is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Na is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains Ni of the first element group, a concentration of Ni may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of Ni is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of Ni is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of Ni is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass ppm, equal to or smaller than 580 mass ppm, equal to or smaller than 550 mass ppm, equal to or smaller than 520 mass ppm, or equal to or smaller than 500 mass ppm.

In a case in which the Al bonding wire or the Al bonding ribbon according to the present invention contains B of the first element group, a concentration of B may be 0 mass ppm, and preferably equal to or larger than 1 mass ppm, equal to or larger than 3 mass ppm, equal to or larger than 5 mass ppm, or equal to or larger than 8 mass ppm. From a viewpoint of reducing the generation frequency of wire breakage in the wire-drawing processing, the concentration of B is more preferably equal to or larger than 10 mass ppm, and still more preferably equal to or larger than 20 mass ppm, equal to or larger than 30 mass ppm, equal to or larger than 40 mass ppm, or equal to or larger than 50 mass ppm. An upper limit of the concentration of B is preferably equal to or smaller than 10000 mass ppm, equal to or smaller than 8000 mass ppm, equal to or smaller than 5000 mass ppm, equal to or smaller than 3000 mass ppm, equal to or smaller than 2000 mass ppm, equal to or smaller than 1000 mass ppm, or equal to or smaller than 900 mass ppm. From a viewpoint of reducing the generation frequency of wire breakage in the wire-drawing processing, the concentration of B is more preferably equal to or smaller than 800 mass ppm, and still more preferably equal to or smaller than 750 mass ppm, equal to or smaller than 740 mass ppm, equal to or smaller than 720 mass ppm, equal to or smaller than 700 mass ppm, equal to or smaller than 680 mass ppm, equal to or smaller than 650 mass ppm, equal to or smaller than 620 mass ppm, equal to or smaller than 600 mass

ppm, equal to or smaller than 580 mass ppm, equal to or smaller than 550 mass ppm, equal to or smaller than 520 mass ppm, or equal to or smaller than 500 mass ppm.

-Addition of Mn, Ti, Fe, Cu, and Mg-

The Al bonding wire or the Al bonding ribbon according to the present invention may further contain one or more of Mn, Ti, Fe, Cu, and Mg (hereinafter, also referred to as a "second element group"). A total concentration of the second element group may be 0 mass ppm, preferably equal to or larger than 1 mass ppm or equal to or larger than 3 mass ppm, more preferably equal to or larger than 5 mass ppm or equal to or larger than 8 mass ppm, still more preferably equal to or larger than 10 mass ppm or equal to or larger than 30 mass ppm, and particularly preferably equal to or larger than 50 mass ppm, equal to or larger than 80 mass ppm, or equal to or larger than 100 mass ppm. An upper limit of the total concentration of the second element group is preferably equal to or smaller than 10000 mass ppm, more preferably equal to or smaller than 8000 mass ppm, still more preferably equal to or smaller than 5000 mass ppm, and particularly preferably equal to or smaller than 3000 mass ppm or equal to or smaller than 2000 mass ppm. In one embodiment, the total concentration of the second element group is preferably equal to or larger than 100 mass ppm and equal to or smaller than 2000 mass ppm.

When the Al bonding wire or the Al bonding ribbon according to the present invention further contains 100 mass ppm or more and 2000 mass ppm or less of one or more of Mn, Ti, Fe, Cu, and Mg in total, generation of scratches and scrapes on the surface of the Al bonding wire or the Al bonding ribbon can be suppressed, and a smooth surface can be formed. In an Al alloy containing a high concentration of Si equal to or larger than 3.0% by mass and equal to or smaller than 20.0% by mass, scratches and/or scrapes may be generated on a surface thereof during the wire-drawing processing and may result in the Al bonding wire or the Al bonding ribbon with large surface unevenness when the surface is hardened and/or the Si phase and Al oxide present on the surface are dropped. It is estimated that scratches and scrapes during the wire-drawing processing can be reduced by adding the second element group to accelerate stabilization of the Al oxide on the surface of the Al bonding wire or the Al bonding ribbon, refinement and hardening of structures of Al crystal grains, and the like. It is considered that an effect of suppressing generation of scratches and scrapes on the surface of the Al bonding wire or the Al bonding ribbon to form a smooth surface can be enhanced by controlling the orientation ratio of the crystal orientation of the Al phase in the ND direction and the orientation ratio of the crystal orientation of the Al phase in the RD direction in the L cross-section and adding the second element group thereto.

From a viewpoint of suppressing generation of scratches and scrapes on the surface to form the Al bonding wire or the Al bonding ribbon having a smooth surface, the total concentration of the second element group in the Al bonding wire or the Al bonding ribbon according to the present invention is more preferably equal to or larger than 150 mass ppm, and still more preferably equal to or larger than 200 mass ppm, equal to or larger than 250 mass ppm, or equal to or larger than 300 mass ppm, and an upper limit thereof is preferably equal to or smaller than 1800 mass ppm, more preferably equal to or smaller than 1600 mass ppm, equal to or smaller than 1500 mass ppm, or equal to or smaller than 1200 mass ppm, still more preferably equal to or smaller than 1000 mass ppm, equal to or smaller than 900 mass ppm, or equal to or smaller than 800 mass ppm, and particularly preferably equal to or smaller than 700 mass ppm, equal to or smaller than 600 mass ppm, or equal to or smaller than 500 mass ppm.

In a case in which the Al bonding wire or the Al bonding ribbon according to the present invention contains one or more elements of the second element group, it may contain any one element of the second element group, may contain any two elements of the second element group, may contain any three elements of the second element group, may contain any four elements of the second element group, or may contain all of five elements of the second element group. In a case in which the Al bonding wire or the Al bonding ribbon according to the present invention contains one or more elements of the second element group, it may contain Mn, may contain Ti, may contain Fe, may contain Cu, and/or may contain Mg.

In a case in which the Al bonding wire or the Al bonding ribbon according to the present invention contains Mn of the second element group, a concentration of Mn may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Mn is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Mn is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Mn is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass

ppm.

In a case in which the Al bonding wire or the Al bonding ribbon according to the present invention contains Ti of the second element group, a concentration of Ti may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Ti is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Ti is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Ti is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Fe of the second element group, a concentration of Fe may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Fe is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Fe is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Fe is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Cu of the second element group, a concentration of Cu may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Cu is more preferably equal to or larger than 100 mass ppm, still more preferably equal to or larger than 150 mass ppm, equal to or larger than 200 mass ppm, equal to or larger than 250 mass ppm, or equal to 300 mass ppm. An upper limit of the concentration of Cu is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Cu is more preferably equal to or smaller than 2000 mass ppm, and still more preferably equal to or smaller than 1800 mass ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

In a case in which the Al bonding wire or the Al bonding ribbon according to the present invention contains Mg of the second element group, a concentration of Mg may be 0 mass ppm, and preferably equal to or larger than 1 mass ppm, equal to or larger than 3 mass ppm, equal to or larger than 5 mass ppm, equal to or larger than 8 mass ppm, equal to or larger than 10 mass ppm, equal to or larger than 30 mass ppm, equal to or larger than 50 mass ppm, or equal to or larger than 80 mass ppm. From a viewpoint of suppressing generation of scratches and scrapes on the surface to form the Al bonding wire or the Al bonding ribbon having a smooth surface, the concentration of Mg is more preferably equal to or larger than 100 mass ppm, and still more preferably equal to or larger than 150 mass ppm, equal to or larger than 200 mass ppm, equal to or larger than 250 mass ppm, or equal to 300 mass ppm. An upper limit of the concentration of Mg is preferably equal to or smaller than 10000 mass ppm, equal to or smaller than 8000 mass ppm, equal to or smaller than 5000 mass ppm, or equal to or smaller than 3000 mass ppm. From a viewpoint of suppressing generation of scratches and scrapes on the surface to form the Al bonding wire or the Al bonding ribbon having a smooth surface, the concentration of Mg is more preferably equal to or smaller than 2000 mass ppm, and still more preferably equal to or smaller than 1800 mass

ppm, equal to or smaller than 1600 mass ppm, equal to or smaller than 1500 mass ppm, equal to or smaller than 1200 mass ppm, equal to or smaller than 1000 mass ppm, equal to or smaller than 900 mass ppm, equal to or smaller than 800 mass ppm, equal to or smaller than 700 mass ppm, equal to or smaller than 600 mass ppm, or equal to or smaller than 500 mass ppm.

As an aluminum raw material for manufacturing the Al bonding wire or the Al bonding ribbon according to the present invention, it is preferable to use Al having a purity of 4N (Al: 99.99% by mass or more), and more preferable to use Al having a purity of 5N (Al: 99.999% by mass or more) in which an amount of impurities is smaller. In one embodiment, Al having a purity of 3N (Al: 99.9 % by mass or more) may be used.

In a range of not inhibiting the effect of the present invention, the Al bonding wire or the Al bonding ribbon according to the present invention may further contain elements other than Al, Si, the first element group, and the second element group (hereinafter, also referred to as "other elements"). That is, the "other elements" mean elements other than Al, Si, Sr, Na, Ni, B, Mn, Ti, Fe, Cu, and Mg, and the Al bonding wire or the Al bonding ribbon according to the present invention may further contain elements other than Al, Si, Sr, Na, Ni, B, Mn, Ti, Fe, Cu, and Mg. A total concentration of the other elements in the Al bonding wire or the Al bonding ribbon is not particularly limited in a range of not inhibiting the effect of the present invention. The total concentration of the other elements may be, for example, equal to or smaller than 0.5% by mass, equal to or smaller than 0.4% by mass, equal to or smaller than 0.3% by mass, equal to or smaller than 0.2% by mass, equal to or smaller than 0.15% by mass, equal to or smaller than 0.1% by mass, equal to or smaller than 0.08% by mass, equal to or smaller than 0.06% by mass, equal to or smaller than 0.05% by mass, equal to or smaller than 0.04% by mass, equal to or smaller than 0.03% by mass, equal to or smaller than 0.025% by mass, equal to or smaller than 0.02% by mass, equal to or smaller than 0.018% by mass, equal to or smaller than 0.016% by mass, equal to or smaller than 0.015% by mass, equal to or smaller than 0.014% by mass, equal to or smaller than 0.012% by mass, or equal to or smaller than 0.01% by mass. A lower limit of the total concentration of the other elements is not particularly limited, and may be 0% by mass.

According to one embodiment, a balance of the Al bonding wire or the Al bonding ribbon according to the present invention consists of Al and other elements. Thus, according to a preferred embodiment, the Al bonding wire or the Al bonding ribbon according to the present invention consists of Al, Si, and other elements. According to another preferred embodiment, the Al bonding wire or the Al bonding ribbon according to the present invention consists of Al, Si, one or more elements of the first element group, and other elements. According to yet another preferred embodiment, the Al bonding wire or the Al bonding ribbon according to the present invention consists of Al, Si, one or more elements of the second element group, and other elements. According to yet another preferred embodiment, the Al bonding wire or the Al bonding ribbon according to the present invention consists of Al, Si, one or more elements of the first element group, one or more elements of the second element group, and other elements.

According to one embodiment, a balance of the Al bonding wire or the Al bonding ribbon according to the present invention consists of Al and inevitable impurities. Thus, according to a preferred embodiment, the Al bonding wire or the Al bonding ribbon according to the present invention consists of Al, Si, and inevitable impurities. According to another preferred embodiment, the Al bonding wire or the Al bonding ribbon according to the present invention consists of Al, Si, one or more elements of the first element group, and inevitable impurities. According to yet another preferred embodiment, the Al bonding wire or the Al bonding ribbon according to the present invention consists of Al, Si, one or more elements of the second element group, and inevitable impurities. According to yet another preferred embodiment, the Al bonding wire or the Al bonding ribbon according to the present invention consists of Al, Si, one or more elements of the first element group, one or more elements of the second element group, and inevitable impurities.

According to a preferred embodiment, the Al bonding wire or the Al bonding ribbon according to the present invention does not have a coating that contains a metal other than Al as a main component on an outer periphery of the Al bonding wire or the Al bonding ribbon. Herein, the "coating that contains a metal other than Al as a main component" means the coating in which the content of the metal other than Al is 50% by mass or more.

The Al bonding wire or the Al bonding ribbon according to the present invention may be an Al bonding wire, and may be an Al bonding ribbon. In a case in which the present invention is the Al bonding wire, a wire diameter thereof is not particularly limited, and may be equal to or larger than 50 μm, equal to or larger than 60 μm, equal to or larger than 80 μm, equal to or larger than 100 μm, equal to or larger than 120 μm, equal to or larger than 140 μm, equal to or larger than 150 μm, equal to or larger than 180 μm, or equal to or larger than 200 μm, for example. An upper limit of the wire diameter is not particularly limited, and may be equal to or smaller than 600 μm, equal to or smaller than 550 μm, equal to or smaller than 500 μm, equal to or smaller than 450 μm, or equal to or smaller than 400 μm, for example. In one embodiment, the wire diameter of the Al bonding wire according to the present invention may fall within a range from 100 to 600 μm, and preferably falls within a range from 200 to 400 μm. In a case in which the present invention is the Al bonding ribbon, dimensions (width W × thickness T) of a cross section having a rectangular shape or a substantially rectangular shape are not particularly limited, for example, W may be 100 to 3000 μm and T may be 50 to 600 μm.

The Al bonding wire or the Al bonding ribbon according to the present invention can exhibit excellent temperature cycle reliability even in the temperature cycle test with a large number of cycles. Thus, the Al bonding wire or the Al bonding

ribbon according to the present invention can be preferably used as an Al bonding wire or an Al bonding ribbon for a semiconductor device. Particularly, the Al bonding wire or the Al bonding ribbon according to the present invention can be preferably used as an Al bonding wire or an Al bonding ribbon for a power semiconductor device, and can be more preferably used as an Al bonding wire or an Al bonding ribbon for a SiC power semiconductor device.

-Method for manufacturing Al bonding wire or Al bonding ribbon-

The following describes an example of a method for manufacturing the Al bonding wire or the Al bonding ribbon according to the present invention. The following describes an example of manufacture of the Al bonding wire.

Al and alloy elements as raw materials preferably have a high purity. Al preferably has a purity of 99.5 % by mass or more and includes inevitable impurities as a balance, more preferably has a purity of 99.9 % by mass or more and includes inevitable impurities as a balance, and still more preferably has a purity of 99.99 % by mass or more and includes inevitable impurities as a balance. Si, the first element group, the second element group, and other elements used as alloy elements preferably have a purity of 99.9% by mass or more and include inevitable impurities as a balance, and more preferably have a purity of 99.99 % by mass or more and include inevitable impurities as a balance. An Al alloy used for the Al bonding wire can be manufactured by loading an Al raw material and raw materials for alloy elements into a crucible made of graphite or alumina that is processed to obtain an ingot having a cylindrical shape, and melting the raw materials by using an electric furnace or a highfrequency heating furnace. A diameter of the ingot having a cylindrical shape is preferably equal to or larger than Φ6 mm and smaller than Φ8 mm while considering processability at a subsequent processing step. An atmosphere in the furnace at the time of melting is preferably an inert atmosphere or a reducing atmosphere to prevent Al, Si, the first element group, the second element group, and other elements constituting the wire from being excessively oxidized. The highest end-point temperature of melted metal at the time of melting preferably falls within a range equal to or higher than 800°C and lower than 1050°C, considering to facilitate control of the shape and the size of the Si phase at the time of solidification and the like while securing fluidity of the melted metal. As a method for cooling at the time of solidification, water cooling, furnace cooling, air cooling, and the like can be used.

By performing solution treatment to heat the ingot having a cylindrical shape obtained by melting at a high temperature, and repeatedly performing wire-drawing processing using dies thereon, the wire having a desired wire diameter can be manufactured. The wire after being subjected to the wire-drawing processing can be used as an Al bonding wire by performing final heat treatment using the electric furnace.

<Control of crystal orientation of Al phase>

To control the crystal orientation of the Al phase in the L cross-section, it is effective to control a heat treatment condition for solution treatment, homogenization processing, intermediate heat treatment, final heat treatment, and/or the like, and a wire-drawing processing condition, and the like. Specifically, distortion energy accumulated inside the Al phase during the wire-drawing processing serves as a driving force for recrystallization in heat treatment, and effectively acts to control the crystal orientation of the Al phase and the size of the Si phase. At the time of wire-drawing processing, it is effective to use a lubricating liquid to secure lubricity at a contact interface between the wire and the die.

The following describes an example of a manufacturing condition for controlling the orientation ratio of the <110> crystal orientation of the Al phase in the ND direction in the L cross-section to fall within a range equal to or larger than 10% and equal to or smaller than 40%, and controlling the orientation ratio of the <100> crystal orientation of the Al phase in the RD direction to fall within a range equal to or larger than 15% and equal to or smaller than 50%.

To adjust the orientation ratio of the <110> crystal orientation of the Al phase in the ND direction and the orientation ratio of the <100> crystal orientation of the Al phase in the RD direction, it is effective to combine control of the intermediate heat treatment condition in the intermediate of wire-drawing and control of the final heat treatment condition.

When a condition for the intermediate heat treatment is adjusted, adjustment of the orientation ratio of the <100> crystal orientation of the Al phase in the RD direction is facilitated. The intermediate heat treatment is heat treatment that is performed in the intermediate of a step of processing the ingot until the final wire diameter is obtained. It is effective to set a temperature range for the intermediate heat treatment to be equal to or higher than 200°C and lower than 400°C, and set a time therefor to be equal to or longer than 1 hour and shorter than 48 hours. The number of times of the intermediate heat treatment preferably falls within a range from 3 to 4. For example, in a case in which the intermediate heat treatment is performed three times, the wire diameter after a first intermediate heat treatment is preferably 6.5 to 8.0 times the final wire diameter, the wire diameter after a second intermediate heat treatment is preferably 4.0 to 5.5 times the final wire diameter, and the wire diameter after a third intermediate heat treatment is preferably 2.0 to 3.5 times the final wire diameter. By performing the intermediate heat treatment, processing distortion of the Al phase is reduced and slight recrystallization is caused, thereby reducing a worked structure of the Al phase at the final wire diameter, increasing a degree of progress of recrystallization of the Al phase in subsequent heat treatment, and accelerating rotation of the crystal orientation, whereby adjustment of the orientation ratio of the <100> crystal orientation of the Al phase in the RD direction is facilitated. On the

other hand, when the intermediate heat treatment temperature is equal to or higher than 400°C, there is a concern that the orientation ratio of the <100> crystal orientation of the Al phase in the RD direction becomes unstable.

Optimizing a combination of temperature conditions for a plurality of intermediate heat treatments is effective for adjusting the orientation ratio of the <100> crystal orientation of the Al phase in the RD direction. For example, in a case in which the intermediate heat treatment is performed twice, when Tm1 (°C) and Tm2 (°C) are respectively defined as temperatures of the intermediate heat treatment at a large diameter and a small diameter, by setting the temperature Tm1 at the large diameter to be higher than the temperature Tm2 at the small diameter (Tm1 > Tm2), recrystallization is allowed to uniformly proceed throughout the wire, whereby adjustment of the orientation ratio of the <100> crystal orientation of the Al phase in the RD direction is facilitated.

Furthermore, as a step prior to performing the intermediate heat treatment, holding at room temperature for 2 days or more and then performing the intermediate heat treatment after the wire-drawing processing is effective for adjusting the orientation ratio of the <110> crystal orientation of the Al phase in the ND direction. By using processing distortion introduced into the Al phase at the wire-drawing processing step as a driving force, recovery is promoted during holding at room temperature by mainly accelerating a climb and annihilation of dislocations in the ND direction and the like, whereby adjustment of the final orientation ratio of the <110> crystal orientation of the Al phase in the ND direction is facilitated. Holding at room temperature is preferably performed in a range from 2 to 20 days, and it is also possible to substitute holding in a constant temperature chamber at 20 to 50°C therefor.

As the final heat treatment condition, it is effective to adjust a temperature range to be equal to or higher than 200°C and lower than 360°C, and adjust a time within a range equal to or longer than 2 hours and shorter than 20 hours. By the final heat treatment, recovery and recrystallization of the Al phase proceed, and at the same time, an amount of Si dissolved in the Al phase as a solid solution is changed depending on a heat treatment temperature, whereby a recrystallization temperature is changed. By adjusting progress of recrystallization by the final heat treatment, alignment of the crystal orientation can be easily controlled. For example, by adjusting the final heat treatment to be performed at a low temperature or in a short time, the orientation ratio of the <110> crystal orientation of the Al phase in the ND direction having high density tends to increase.

<Control of average diameter of Al phase>

To control the average diameter of the Al phase in the L cross-section to fall within a range equal to or larger than 5.0 μm and equal to or smaller than 40.0 μm, it is effective to adjust a temperature and a time for heat treatment at the final wire diameter, and control growth of the crystal grains due to recrystallization of the Al phase. Specifically, it is exemplified that the temperature for the final heat treatment is controlled within a range equal to or higher than 200 °C and lower than 300 °C, and the time for the final heat treatment is controlled within a range equal to or longer than 2 hours and shorter than 72 hours. By adjusting the solid solution amount of Si contained in the Al phase by performing heat treatment for a long time at a relatively low temperature, it is possible to easily control progress of recrystallization of the Al phase and control the average diameter of the Al phase to fall within a desired range.

<Control of average diameter of Si phase>

To adjust the average diameter of the Si phase in the L cross-section to fall within a range equal to or larger than 0.8 μm and equal to or smaller than 4.0 μm, it is effective to adjust a temperature at the time of melting in manufacture of the ingot in a range equal to or higher than 800°C and lower than 1050°C, and to control a temperature for the solution treatment in a range equal to or higher than 450°C and lower than 550°C and control a time for the solution treatment in a range equal to or longer than 1 hour and shorter than 6 hours. When the temperature for the solution treatment is high, the columnar Si phase is fragmented and granulated, and the average diameter of the Si phase tends to be reduced. To further reduce the average diameter of the Si phase, it is effective to increase a cooling speed at the time of solidification, for example, to perform water cooling.

Earlier mentioned, as a representative example, the example of manufacture of the Al bonding wire as a wire material has been described above. The Al bonding ribbon as a bar material can also be manufactured basically through the same procedure. As the temperature and the time for the heat treatment, substantially the same conditions as described above can be used. In a case of manufacturing the Al bonding ribbon by rolling processing, an area reduction ratio of a die may be replaced with a rolling reduction ratio to be adjusted.

[Semiconductor device]

The semiconductor device can be manufactured by connecting the electrode on the semiconductor chip to the lead frame or an external electrode on the substrate by using the Al bonding wire or the Al bonding ribbon according to the present invention. That is, the semiconductor device according to the present invention comprises the Al bonding wire or

the Al bonding ribbon according to the present invention. As described above, wedge bonding is used for both of the 1st bonding with the electrode on the semiconductor chip and the 2nd bonding with the lead frame or the electrode on the substrate.

In one embodiment, the semiconductor device according to the present invention comprises a circuit board, the semiconductor chip, and the Al bonding wire or the Al bonding ribbon for bringing the circuit board and the semiconductor chip into conduction with each other, and is characterized in that the Al bonding wire or the Al bonding ribbon is the Al bonding wire or the Al bonding ribbon according to the present invention.

In the semiconductor device according to the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in Japanese Patent Application Laid-open No. 2020-150116, the semiconductor device may comprise a lead frame and a semiconductor chip mounted on the lead frame.

Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

Hereinafter, the present invention will be described in detail with reference to Examples. However, the present invention is not limited to the following Examples.

(Sample)

A method for producing a sample will be described. As a raw material, Al having a purity of 4N (99.99% by mass or more) and including inevitable impurities as a balance was used. Si, the first element group (Sr, Na, Ni, B), the second element group (Mn, Ti, Fe, Cu, Mg), and other elements (Zn, Sn) used as alloy elements each having a purity of 99.99% by mass or more and including inevitable impurities as a balance were also used. The Al alloy used for the Al bonding wire or the Al bonding ribbon was manufactured by loading an Al raw material and raw materials for the alloy elements into an alumina crucible, and melting them by using a high-frequency heating furnace. An atmosphere inside the furnace at the time of melting was an Ar atmosphere, and the highest end-point temperature of melted metal at the time of melting was set to be equal to or higher than 800°C and lower than 1050°C. The cooling method at the time of solidification was air cooling for performing cooling in the air, or water cooling for performing cooling in water.

After an ingot of Φ6 mm having a cylindrical shape was obtained by melting, and the ingot was subjected to solution treatment and homogenization processing, wire-drawing processing using dies and intermediate heat treatment were performed to produce an Al bonding wire of Φ300 μm. By using the Al bonding wire of Φ300 μm as a starting material, an Al bonding ribbon having a thickness of 100 μm and a width of 600 μm was manufactured by two-step rolling. A temperature range for the solution treatment was set to be equal to or higher than 500°C and lower than 550°C, and a time therefor was set to be equal to or longer than 2 hours and shorter than 4 hours. Homogenization processing was successively performed in the intermediate of cooling after the solution treatment was ended. A temperature range for the homogenization processing was set to be equal to or higher than 250°C and lower than 350°C, and a time therefor was set to be equal to or longer than 2 hours and shorter than 5 hours. The cooling method after the homogenization processing was air cooling for performing cooling in the air.

The intermediate heat treatment was performed three to four times. Regarding the wire diameter after the intermediate heat treatment relative to the final wire diameter, first intermediate annealing was performed in a range from 7.0 to 8.0 times, second intermediate annealing was performed in a range from 4.0 to 5.0 times, and third intermediate annealing was performed in a range from 2.5 to 3.5 times, respectively. In a case in which the intermediate heat treatment was performed four times, the intermediate annealing was additionally performed at a wire diameter in a range from 5.5 to 6.5 times the final wire diameter. A temperature range for the intermediate heat treatment was set such that, for the first and second intermediate heat treatments, a temperature was equal to or higher than 300°C and lower than 400°C and a time was equal to or longer than 1 hour and shorter than 3 hours, and for the third and fourth intermediate heat treatments, the temperature was equal to or higher than 200°C and lower than 300°C and the time was equal to or longer than 4 hours and shorter than 48 hours, respectively. In addition, after the wire-drawing processing, the intermediate heat treatment was performed after holding at room temperature for 2 days or more and 7 days or less.

A commercially available lubricating liquid was used at the time of the wire-drawing processing, and an area reduction ratio of the wire per die at the time of the wire-drawing processing was equal to or larger than 12.5% and smaller than 16.0%. A temperature range for the final heat treatment was set to be equal to or higher than 250°C and lower than 360°C, and a time for the final heat treatment was set to be equal to or longer than 2 hours and shorter than 20 hours.

In some examples, the wire-drawing processing was performed using dies having a die angle equal to or larger than 14° and smaller than 18°.

(Method for measuring element content)

For concentration analysis of elements contained in the Al bonding wire or the Al bonding ribbon, Inductively Coupled Plasma-Optical Emission Spectrometer (ICP-OES) ("PS3520UVDDII" manufactured by Hitachi High-Tech Science Corporation) or Inductively Coupled Plasma-Mass Spectrometer (ICP-MS) ("Agilent 7700x ICP-MS" manufactured by Agilent Technologies, Inc.) was used as an analysis apparatus.

(Method for measuring orientation ratio of crystal orientation of Al phase)

The L cross-section (cross section in the center axis direction including the center axis) of the Al bonding wire or the Al bonding ribbon was designated as the inspection surface, and the crystal orientation of the Al phase was measured.

An FE-SEM (SU-70 manufactured by Hitachi High-Tech Corporation) was used for measurement, and APEX (for data collection) manufactured by TSL solutions KK, OIM Data Collection (for Chi Scan), and OIM Analysis (for data analysis) were used as analysis software. Measurement regions at three parts were randomly selected at intervals of 50 cm or more with respect to the center axis direction of the Al bonding wire or the Al bonding ribbon, and the regions at the three parts were measured. The measurement region was determined so that a size thereof in the center axis direction of the Al bonding wire or the Al bonding ribbon was equal to or larger than 300 μm and smaller than 800 μm, and the entire Al bonding wire or Al bonding ribbon was accommodated therein in the direction perpendicular to the center axis. As a main condition for EDS and EBSD measurement, an acceleration voltage was set to be 15 kV, a measurement magnification was set to be 350-fold, a scan speed was set to be 30 to 120 points/second, and a measurement interval was set to fall within a range from 0.1 to 0.3 μm. Herein, if the scan speed is high, the measurement time can be shortened, but there is concern that measurement accuracy of the EDS may be lowered. It is preferable to select an appropriate scan speed in the range described above.

In measuring the orientation ratio of the crystal orientation of the Al phase in the L cross-section of the Al bonding wire or the Al bonding ribbon, the SEM-EDS-EBSD apparatus was used, and a method of combining information of Al concentration and Si concentration obtained by the SEM-EDS and information of a crystal orientation obtained by the EBSD was used. More specifically, measurement was performed in accordance with procedures from (1) to (3) as follows.

(1) In the measurement region designating the L cross-section of the Al bonding wire or the Al bonding ribbon to be the inspection surface, measurement of concentration of Al and Si using the EDS and crystal orientation measurement using the EBSD were performed at the same time.

(2) Al and Si were separated and extracted by using the Chi Scan function as a function of EBSD analysis software. Specifically, Al and Si were separated and identified by setting Tolerance corresponding to a threshold of Si based on a measurement result of the EDS for Si. The crystal information of Al and Si in the material file was used for analyzing the crystal orientation. Herein, a condition for Tolerance was mainly set to be 30%, and adjusted as needed.

(3) For the region that was specified as the Al phase, the crystal orientations were analyzed, and the orientation ratio of the <100> crystal orientation of the Al phase in the RD direction and the orientation ratio of the <110> crystal orientation of the Al phase in the ND direction were calculated. As crystal orientations to be investigated, at least three types of <111>, <110>, and <100>, which are representative crystal orientations of Al metal, were selected, and crystal orientations having high ratios were selected as needed. Herein, as the orientation ratio of the crystal orientation, a partial ratio was used.

The orientation ratio of the <100> crystal orientation of the Al phase in the RD direction and the orientation ratio of the <110> crystal orientation of the Al phase in the ND direction were calculated as average values (arithmetic means) of respective values obtained for measurement regions at three parts through the procedures from (1) to (3) described above.

(Method for measuring average diameter of Al phase)

In measuring the average diameter of the Al phase in the L cross-section of the Al bonding wire or the Al bonding ribbon, similarly to measurement of the orientation ratio of the crystal orientation of the Al phase, the SEM-EDS-EBSD apparatus was used, and a method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows.

(3) For the region that was specified as the Al phase, the crystal orientation was analyzed, and if the orientation difference between measurement points was equal to or larger than 15°, it was determined to be the crystal grain boundary, and the equivalent circle diameter of each crystal grain was obtained. An average of equivalent circle diameters of the respective crystal grains was calculated to obtain the average diameter of the Al phase. Herein, regarding average calculation, an average value obtained by Area average (area-weighted average), which can be selected by the software attached to the

apparatus, was used. In calculating the average diameter of the Al phase in the L cross-section, only Al phases having a diameter (equivalent circle diameter) equal to or larger than 0.5 μm were considered as targets.

The average diameter of the Al phase was calculated as an average value (arithmetic mean) of respective values obtained for measurement regions at three parts through the procedures from (1) to (3) described above.

(Method for measuring average diameter of Si phase)

In measuring the average diameter of the Si phase in the L cross-section of the Al bonding wire or the Al bonding ribbon, similarly to measurement of the crystal orientation of the Al phase, the SEM-EDS-EBSD apparatus was used, and the method of combining information of Al concentration and Si concentration obtained by the SEM-EDS and information of a crystal orientation obtained by the EBSD was used. Specifically, after performing the procedures (1) and (2) described above, measurement was performed through the procedure (3) as follows.

(3) For the region that was specified as the Si phase, the crystal orientation was analyzed, and if the orientation difference between measurement points was equal to or larger than 15°, it was determined to be the crystal grain boundary, and the equivalent circle diameter of each crystal grain was obtained. An average of equivalent circle diameters of the respective crystal grains was calculated to obtain the average diameter of the Si phase. Herein, an average value obtained by Area average (area-weighted average) was used for average calculation. In calculating the average diameter of the Si phase in the L cross-section, only Si phases having a diameter (equivalent circle diameter) equal to or larger than 0.5 μm were considered as targets.

The average diameter of the Si phase was calculated as an average value (arithmetic mean) of respective values obtained for measurement regions at three parts through the procedures from (1) to (3) described above.

(Method for evaluating Al bonding wire or Al bonding ribbon)

The following describes a method for evaluating the Al bonding wire. The wire diameter of the Al bonding wire used for evaluation was Φ300 μm. The semiconductor chip made of Si was used, and as the electrode on the semiconductor chip, used was an alloy having a composition of Al-0.5%Cu deposited to have a thickness of 4 μm. As a substrate, 5 μm of Ni was deposited on an Al alloy. For bonding of the Al bonding wire, a commercially available wire bonder (manufactured by ULTRASONIC ENGINEERING CO., LTD.) was used, and wedge bonding was used for both of the 1st bonding (bonding with the electrode described above on the semiconductor chip) and the 2nd bonding (bonding with the substrate described above). For bonding of the Al bonding ribbon, a fully automatic bonder "BJ955" that is manufactured by Hesse GmbH and equipped with a ribbon bond head was used.

(Method for evaluating temperature cycle reliability)

For evaluation of the temperature cycle test, a commercially available thermal shock test apparatus was used. In the temperature cycle test, a temperature rise and a temperature fall are repeated as a sample chamber moves between a low-temperature tank and a high-temperature tank. A temperature of the low-temperature tank was set to be -40°C, and a temperature of the high-temperature tank was set to be 175°C. The test was started in a state in which the sample chamber was present in the high-temperature tank, and one cycle was defined as a period from when the sample chamber moved to the low-temperature tank until it returned to the high-temperature tank. A time during which the sample chamber stayed in each of the low-temperature tank and the high-temperature tank was set to be 20 minutes. A sample to be subjected to the temperature cycle test had a structure in which a semiconductor chip was mounted on a substrate, and an electrode on the semiconductor chip was connected with an electrode on the substrate via the Al bonding wire or the Al bonding ribbon. After the test was started, the sample was taken out after 2000 cycles, and a shear test was performed on the 1st bonding part. As a value of shear force of the 1st bonding part used for evaluating the temperature cycle reliability, an average value of shear force of 1st bonding parts at five points, which were randomly extracted, was used. Evaluation was performed based on a force ratio (F2/F1) of a shear force value F2 after the temperature cycle test to a shear force value F1 before the temperature cycle test. If the force ratio was smaller than 50%, it was determined that, as evaluation for a SiC semiconductor, there was a problem in a practical use and evaluated as "0". If the force ratio was equal to or larger than 50% and smaller than 70%, it was determined that improvement was required and evaluated as "1". If the force ratio was equal to or larger than 70% and smaller than 75%, it was determined to be excellent and evaluated as "2". If the force ratio was equal to or larger than 75%, it was determined to be especially excellent and evaluated as "3". "0" and "1" are unacceptable, and "2" and "3" are acceptable. Evaluation results are described in a column of "Temperature cycle reliability" in tables.

(Method for evaluating variation in bonding strength in temperature cycle test)

In the temperature cycle test described above, shear force was measured for 1st bonding parts at twenty parts after 2000 cycles of the test. In evaluating variation in bonding strength in the temperature cycle test, an unbiased standard deviation ($\sigma$) of shear force was calculated. Since an unbiased standard deviation of shear force of the 1st bonding part is less likely to be influenced by conditions of the 1st bonding, it is useful as an index for appropriately evaluating characteristics of the Al bonding wire or the Al bonding ribbon. If $\sigma$ was smaller than 30 gf, it was determined that variation in bonding strength was particularly small and stability was excellent, and evaluated as "3". If $\sigma$ was equal to or larger than 30 gf and smaller than 50 gf, it was determined that variation in bonding strength was small and stability was excellent, and evaluated as "2". If $\sigma$ was equal to or larger than 50 gf and smaller than 70 gf, it was determined that variation in bonding strength fell within a permissible range and stability was favorable, and evaluated as "1". If $\sigma$ was equal to or larger than 70 gf, it was determined that variation in bonding strength was large and there was a problem in a practical use, and described as "0". Evaluation results are described in a column of "Temperature cycle reliability, variation in bonding strength (2000 times)" in the tables.

(Method for evaluating hollow at 1st bonding part)

The following describes a method for evaluating a hollow defect at the 1st bonding part. The 1st bonding was performed at ten parts under a general bonding condition, and the shear force of the 1st bonding part was measured. For measurement of the shear force, a commercially available micro shear force tester (4000-PLUS manufactured by Nordson Corporation) was used. A shear rate was set to be 200 μm/sec, and a height of a shearing tool was set to be 10 μm from an electrode surface. The shear force was measured by fixing, with a jig, a substrate to which the Al bonding wire or the Al bonding ribbon was bonded. After performing the shear force test on the 1st bonding part described above, an impression on a broken surface on the electrode side was observed by an optical microscope or an SEM, and a part where metallic bonding is not achieved in a broken region was determined to be a hollow. The part where the hollow is generated is a part that is not bonded even when the electrode is deformed, and can be discriminated from a region in which metallic bonding is achieved. The shear force test was performed under the condition described above, and broken surfaces at ten parts of the 1st bonding part were observed. A ratio of a total length (K) of a hollow region in a bonding width direction to a bonding length (J) in a direction perpendicular to the center axis of the Al bonding wire or the Al bonding ribbon (bonding width direction) was obtained as a hollow ratio (K/J) (FIG. 3). Hollow ratios are checked for the broken surfaces at ten parts, and a "hollow defect rate" is defined as a maximum value thereof. If the hollow defect rate was smaller than 5%, it was determined to be favorable and evaluated as "3". If the hollow defect rate was equal to or larger than 5% and smaller than 15%, it was determined that there was no problem in a practical use and evaluated as "2". If the hollow defect rate was equal to or larger than 15% and smaller than 25%, it was determined that improvement was required and evaluated as "1". If the hollow defect rate was equal to or larger than 25%, it was determined to be an obstruction to mass production and evaluated as "0". Evaluation results are described in a column of "Hollow at 1st bonding part" in the tables.

(Method for evaluating wire breakage during processing)

The following describes a method for evaluating wire breakage during processing. Wire-drawing processing was performed from a wire diameter of 6 mmφ to a wire diameter of 0.3 mmφ, and the number of times of wire breakage was checked. The feeding speed, the area reduction ratio, and the like as processing conditions for wire-drawing are selected from the conditions described above, and appropriate manufacturing conditions are adjusted or changed for each wire. The length of the drawn Al bonding wire fell within a range from 100 to 200 m, and the number of times of wire breakage was calculated in terms of 100 m. If the number of times of wire breakage was 0, it was determined to be favorable and evaluated as "3". If the number of times of wire breakage was 1, it was determined to be able to be handled by improving the manufacturing condition and evaluated as "2". If the number of times of wire breakage was 2 to 4, lowering of productivity was regarded as a problem and evaluated as "1". If the number of times of wire breakage was 5 or more, it was determined that a practical use was difficult to be achieved and evaluated as "0". Evaluation results are described in a column of "Wire breakage during processing" in the tables.

(Method for evaluating scratch and scrape on surface)

A surface property of the Al bonding wire or the Al bonding ribbon was evaluated focusing on scratches and scrapes. The wire diameter of the Al bonding wire was Φ300 μm. A thickness of the Al bonding ribbon was 100 μm, and a width thereof was 600 μm. Measurement regions at three parts were randomly selected at intervals of 1 m or more with respect to the center axis direction of the Al bonding wire or the Al bonding ribbon, and three samples each having a length of about 2 cm were taken at each of the three parts to observe nine samples in total. Specifically, the surface was observed

with magnification in a range from 50-fold to 500-fold using the SEM. A scratch having a length equal to or larger than 50 μm or a scrape having a length equal to or larger than 30 μm were determined to be defects. Parts of scratches or scrapes were counted. If the number thereof was 0, it was determined to be favorable and acceptable, and evaluated as "3". If the number thereof was equal to or larger than 1 and equal to or smaller than 2, it was determined that there was no problem in a practical use and evaluated as "2". If the number thereof was 3 to 7, it was determined that the surface property was not good, and evaluated as "1". If the number thereof was equal to or larger than 8, it was determined that a practical use was difficult to be achieved and evaluated as "0". Evaluation results are described in a column of "Surface property" in the tables.

The evaluation results of Examples and Comparative Examples are indicated in Table 1 to Table 4. Examples 1 to 51 and Comparative Examples 1 to 10 in Table 1 to Table 3 are results related to the Al bonding wire, and Examples B1 to B3 and Comparative Example B1 in Table 4 are results related to the Al bonding ribbon.

[Table 1]

(Table 1)

| | No. | Contained element and concentration | | | | | | | | | | | | | RD Al phase <100> ratio (%) | ND Al phase <110> ratio (%) | Average diameter of Al phase (μm) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Ni (mass ppm) | B (mass ppm) | Mn (mass ppm) | Ti (mass ppm) | Fe (mass ppm) | Cu (mass ppm) | Mg (mass ppm) | Other elements (mass ppm) | Total of first element group (mass ppm) | Total of second element group (mass ppm) | | | | | Temperature cycle reliability | Temperature cycle reliability, variation in bonding strength (2000 times) | Hollow at 1st bonding part | Wire breakage during processing | Surface property |
| Example | 1 | 3.0 | | | | | | | | | | | 0 | 0 | 25 | 13 | 14.2 | 0.6 | 2 | 3 | 2 | 2 | 2 |
| | 2 | 3.5 | | | | | | | | | | | 0 | 0 | 35 | 22 | 32.2 | 1.6 | 3 | 2 | 3 | 2 | 2 |
| | 3 | 4.0 | | | | | | | | | | | 0 | 0 | 50 | 32 | 21.8 | 2.2 | 3 | 3 | 3 | 2 | 2 |
| | 4 | 4.6 | | | | | | | | | | | 0 | 0 | 32 | 18 | 30.4 | 2.5 | 3 | 2 | 3 | 2 | 2 |
| | 5 | 5.0 | | | | | | | | | | | 0 | 0 | 30 | 25 | 21.2 | 3.1 | 3 | 3 | 2 | 2 | 2 |
| | 6 | 5.4 | | | | | | | | | | | 0 | 0 | 40 | 10 | 18.0 | 2.3 | 2 | 3 | 3 | 2 | 2 |
| | 7 | 6.0 | | | | | | | | | | | 0 | 0 | 22 | 32 | 23.6 | 1.5 | 3 | 3 | 3 | 2 | 2 |
| | 8 | 6.3 | | | | | | | | | | | 0 | 0 | 18 | 40 | 13.5 | 3.2 | 2 | 3 | 3 | 2 | 2 |
| | 9 | 6.7 | | | | | | | | | | | 0 | 0 | 42 | 17 | 18.3 | 0.7 | 3 | 3 | 2 | 2 | 2 |
| | 10 | 7.0 | | | | | | | | | | | 0 | 0 | 25 | 37 | 22.3 | 2.2 | 3 | 3 | 3 | 2 | 2 |
| | 11 | 7.0 | | | | | | | | | | | 0 | 0 | 45 | 27 | 28.4 | 0.8 | 3 | 3 | 2 | 2 | 2 |
| | 12 | 7.2 | | | | | | | | | | | 0 | 0 | 15 | 25 | 16.7 | 2.4 | 2 | 3 | 3 | 2 | 2 |
| | 13 | 7.5 | | | | | | | | | | | 0 | 0 | 35 | 31 | 4.7 | 1.3 | 3 | 2 | 3 | 2 | 2 |
| | 14 | 7.8 | | | | | | | | | | | 0 | 0 | 28 | 40 | 14.4 | 2.3 | 3 | 3 | 3 | 2 | 2 |
| | 15 | 8.0 | | | | | | | | | | | 0 | 0 | 47 | 14 | 18.2 | 3.3 | 2 | 3 | 3 | 2 | 2 |
| | 16 | 8.2 | | | | | | | | | | | 0 | 0 | 48 | 28 | 27.6 | 2.2 | 3 | 3 | 3 | 2 | 2 |
| | 17 | 9.0 | | | | | | | | | | | 0 | 0 | 21 | 32 | 13.9 | 4.1 | 3 | 3 | 2 | 2 | 2 |
| | 18 | 9.5 | | | | | | | | | | | 0 | 0 | 42 | 30 | 8.5 | 3.0 | 3 | 3 | 3 | 2 | 2 |
| | 19 | 10.0 | | | | | | | | | | | 0 | 0 | 35 | 17 | 15.0 | 0.7 | 3 | 3 | 2 | 2 | 2 |
| | 20 | 11.5 | | | | | | | | | | | 0 | 0 | 17 | 20 | 13.8 | 2.4 | 2 | 3 | 3 | 2 | 2 |
| | 21 | 13.1 | | | | | | | | | | | 0 | 0 | 20 | 14 | 13.2 | 1.8 | 2 | 3 | 3 | 2 | 2 |
| | 22 | 15.2 | | | | | | | | | | | 0 | 0 | 32 | 25 | 4.2 | 2.8 | 3 | 2 | 3 | 2 | 2 |
| | 23 | 17.6 | | | | | | | | | | | 0 | 0 | 30 | 23 | 7.3 | 3.0 | 3 | 3 | 3 | 2 | 2 |

[Table 2]

(Table 2)

| | No. | Contained element and concentration | | | | | | | | | | | | | RD Al phase <100> ratio (%) | ND Al phase <110> ratio (%) | Average diameter of Al phase (μm) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Ni (mass ppm) | B (mass ppm) | Mn (mass ppm) | Ti (mass ppm) | Fe (mass ppm) | Cu (mass ppm) | Mg (mass ppm) | Other elements (mass ppm) | Total of first element group (mass ppm) | Total of second element group (mass ppm) | | | | | Temperature cycle reliability | Temperature cycle reliability, variation in bonding strength (2000 times) | Hollow at 1st bonding part | Wire breakage during processing | Surface property |
| Example | 24 | 6.3 | 10 | | | | | | | | | | 10 | 0 | 17 | 32 | 20.3 | 1.5 | 2 | 3 | 3 | 3 | 2 |
| | 25 | 5.2 | 80 | | | | | | | | | | 80 | 0 | 32 | 22 | 30.8 | 0.7 | 3 | 2 | 2 | 3 | 2 |
| | 26 | 7.0 | 130 | | | | | | | | | | 130 | 0 | 22 | 18 | 16.2 | 2.0 | 3 | 3 | 3 | 3 | 2 |
| | 27 | 8.2 | 230 | | | | | | | | | | 230 | 0 | 50 | 24 | 18.8 | 1.7 | 3 | 3 | 3 | 3 | 2 |
| | 28 | 6.6 | 420 | | | | | | | | | | 420 | 0 | 35 | 36 | 18.2 | 0.8 | 3 | 3 | 3 | 3 | 2 |
| | 29 | 8.0 | | 170 | | | | | | | | | 170 | 0 | 44 | 23 | 22.7 | 2.8 | 3 | 3 | 3 | 3 | 2 |
| | 30 | 5.5 | | | 8 | | | | | | | | 8 | 0 | 25 | 40 | 15.5 | 2.2 | 3 | 3 | 3 | 2 | 2 |
| | 31 | 7.0 | | | 450 | | | | | | | | 450 | 0 | 27 | 32 | 8.7 | 3.6 | 3 | 2 | 3 | 3 | 2 |
| | 32 | 9.0 | | | | 45 | | | | | | | 45 | 0 | 31 | 24 | 15.0 | 2.7 | 3 | 3 | 3 | 3 | 2 |
| | 33 | 6.0 | 100 | | 50 | | | | | | | | 150 | 0 | 47 | 16 | 24.8 | 1.7 | 3 | 3 | 3 | 3 | 2 |
| | 34 | 14.7 | 320 | 450 | | | | | | | | | 770 | 0 | 22 | 23 | 23.5 | 2.8 | 3 | 3 | 2 | 3 | 2 |
| | 35 | 9.5 | 180 | | 300 | 80 | | | | | | Zn: 2400 | 560 | 0 | 26 | 14 | 19.3 | 2.2 | 2 | 3 | 3 | 3 | 2 |
| | 36 | 6.0 | | 280 | 380 | 150 | | | | | | | 810 | 0 | 18 | 21 | 13.7 | 1.4 | 2 | 3 | 3 | 2 | 2 |
| | 37 | 6.3 | | | | | 450 | | | | | | 0 | 450 | 32 | 33 | 12.4 | 3.2 | 3 | 3 | 3 | 2 | 3 |
| | 38 | 4.0 | | | | | | 180 | | | | | 0 | 180 | 29 | 33 | 16.3 | 3.7 | 3 | 3 | 3 | 2 | 3 |
| | 39 | 6.0 | | | | | | | 90 | | | | 0 | 90 | 50 | 25 | 21.3 | 2.8 | 3 | 3 | 3 | 2 | 2 |
| | 40 | 7.2 | | | | | | | 620 | | | | 0 | 620 | 25 | 18 | 24.3 | 2.6 | 3 | 3 | 3 | 2 | 3 |
| | 41 | 4.8 | | | | | | | | 330 | | | 0 | 330 | 27 | 11 | 27.5 | 3.0 | 2 | 3 | 3 | 2 | 3 |
| | 42 | 6.5 | | | | | | | | | 120 | | 0 | 120 | 34 | 13 | 31.1 | 2.6 | 2 | 2 | 3 | 2 | 3 |
| | 43 | 6.0 | | | | | | 100 | | 200 | 70 | | 0 | 370 | 42 | 16 | 22.4 | 2.4 | 3 | 3 | 3 | 2 | 3 |
| | 44 | 8.0 | | | | | 220 | 80 | 40 | 420 | | | 0 | 760 | 17 | 22 | 4.4 | 2.8 | 2 | 2 | 3 | 2 | 3 |
| | 45 | 7.5 | | | | | | 520 | 120 | 780 | 320 | | 0 | 1740 | 29 | 32 | 21.5 | 3.3 | 3 | 3 | 3 | 2 | 3 |
| | 46 | 7.8 | 120 | | | | | 220 | 120 | | | | 120 | 340 | 33 | 40 | 17.4 | 1.6 | 3 | 3 | 3 | 3 | 3 |
| | 47 | 13.2 | 220 | | 125 | | | 240 | 220 | | | | 345 | 460 | 40 | 12 | 19.5 | 1.0 | 2 | 3 | 3 | 3 | 3 |
| | 48 | 5.5 | | 200 | | 80 | 40 | 300 | | 70 | | Sn: 1800 | 280 | 410 | 22 | 20 | 25.7 | 1.7 | 3 | 3 | 3 | 3 | 3 |
| | 49 | 6.0 | | | 200 | | 150 | | | 150 | | | 200 | 300 | 48 | 15 | 21.4 | 3.2 | 3 | 3 | 3 | 3 | 3 |
| | 50 | 9.0 | 25 | | 40 | 100 | 350 | 820 | 50 | 600 | 220 | | 165 | 2040 | 32 | 20 | 16.3 | 4.1 | 3 | 3 | 2 | 3 | 2 |
| | 51 | 6.0 | | | 220 | 120 | | 150 | 110 | | | | 340 | 260 | 28 | 32 | 15.6 | 2.5 | 3 | 3 | 3 | 3 | 3 |

[Table 3]

(Table 3)

| | No. | Contained element and concentration | | | | | | | | | | | | | RD Al phase <100> ratio (%) | ND Al phase <110> ratio (%) | Average diameter of Al phase (μm) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Ni (mass ppm) | B (mass ppm) | Mn (mass ppm) | Ti (mass ppm) | Fe (mass ppm) | Cu (mass ppm) | Mg (mass ppm) | Other elements (mass ppm) | Total of first element group (mass ppm) | Total of second element group (mass ppm) | | | | | Temperature cycle reliability | Temperature cycle reliability, variation in bonding strength (2000 times) | Hollow at 1st bonding part | Wire breakage during processing | Surface property |
| Comparative example | 1 | 0.0 | | | | | | | | | | | 0 | 0 | 23 | 2 | 39.4 | — | 0 | 0 | 2 | 2 | 2 |
| | 2 | 2.8 | | | | | | | | | | | 0 | 0 | 34 | 8 | 27.2 | 0.5 | 0 | 0 | 1 | 2 | 1 |
| | 3 | 24.3 | | | | | | | | | | | 0 | 0 | 25 | 21 | 5.4 | 4.6 | 1 | 1 | 2 | 0 | 0 |
| | 4 | 6.3 | | | | | | | | | | | 0 | 0 | 13 | 22 | 20.2 | 3.0 | 1 | 1 | 1 | 0 | 1 |
| | 5 | 4.2 | | | | | | | | | | | 0 | 0 | 52 | 33 | 18.2 | 2.5 | 1 | 1 | 1 | 0 | 1 |
| | 6 | 7.2 | | | | | | | | | | | 0 | 0 | 19 | 8 | 28.4 | 2.8 | 1 | 1 | 1 | 0 | 1 |
| | 7 | 8.2 | | 200 | | | | | | | | | 200 | 0 | 19 | 43 | 17.8 | 2.7 | 1 | 1 | 1 | 1 | 1 |
| | 8 | 6.7 | | | | 40 | | 200 | | | 250 | | 40 | 450 | 13 | 32 | 24.7 | 3.5 | 1 | 1 | 2 | 1 | 2 |
| | 9 | 7.2 | 150 | | | | | | 220 | | | | 150 | 220 | 54 | 28 | 27.1 | 2.2 | 1 | 1 | 2 | 1 | 2 |
| | 10 | 5.0 | | 230 | 50 | | | | | | | | 280 | 0 | 57 | 8 | 16.3 | 2.8 | 1 | 1 | 2 | 1 | 1 |

[Table 4]

(Table 4)

| | No. | Contained element and concentration | | | | | | | | | | | | | RD Al phase <100> ratio (%) | ND Al phase <110> ratio (%) | Average diameter of Al phase (μm) | Average diameter of Si phase (μm) | Evaluation result | | | | |
|---|---|---|---|---|---|---|---|---|---|---|---|---|---|---|---|---|---|---|---|---|---|---|---|
| | | Si (% by mass) | Sr (mass ppm) | Na (mass ppm) | Ni (mass ppm) | B (mass ppm) | Mn (mass ppm) | Ti (mass ppm) | Fe (mass ppm) | Cu (mass ppm) | Mg (mass ppm) | Other elements (mass ppm) | Total of first element group (mass ppm) | Total of second element group (mass ppm) | | | | | Temperature cycle reliability | Temperature cycle reliability, variation in bonding strength (2000 times) | Hollow at 1st bonding part | Wire breakage during processing | Surface property |
| Example | B1 | 5.0 | | | 40 | | | | | | | | 40 | 0 | 28 | 20 | 22.8 | 0.9 | 2 | 3 | 2 | 1 | 2 |
| | B2 | 7.5 | 68 | | | | | | | | | | 68 | 0 | 42 | 35 | 17.7 | 2.6 | 3 | 2 | 3 | 1 | 2 |
| | B3 | 13.2 | 176 | | | 30 | | 85 | | 85 | | | 206 | 170 | 38 | 25 | 14.5 | 2.9 | 3 | 3 | 3 | 0 | 1 |
| Comparative example | B1 | 8.8 | | | | | 70 | | | | | | 0 | 70 | 12 | 9 | 8.6 | 4.2 | 1 | 1 | 1 | 1 | 2 |

[Description of reference signs]

| | |
|---|---|
| 1 | Al bonding wire |
| 10 | center axis |
| 11 | L cross-section |
| 2 | Al bonding ribbon |
| 20 | center axis |
| 21 | L cross-section |
| 3 | Al bonding wire |
| 30 | broken part |
| 31 | hollow |

## Claims

1. An Al bonding wire or an Al bonding ribbon containing 3.0 % by mass or more and 20.0 % by mass or less of Si, wherein when a crystal orientation of an Al phase in an L cross-section (cross section in a center axis direction including a center axis) of the Al bonding wire or the Al bonding ribbon is measured, an orientation ratio of a <110> crystal orientation angled at 15° or less to a direction perpendicular to the center axis (ND direction) is equal to or larger than 10% and equal to or smaller than 40%, and an orientation ratio of a <100> crystal orientation angled at 15° or less to a direction parallel to the center axis (RD direction) is equal to or larger than 15% and equal to or smaller than 50%.

2. The Al bonding wire or the Al bonding ribbon according to claim 1, wherein an average diameter of the Al phase in the L cross-section is equal to or larger than 5.0 μm and equal to or smaller than 40.0 μm.

3. The Al bonding wire or the Al bonding ribbon according to claim 1 or 2, wherein an average diameter of a Si phase in the L cross-section is equal to or larger than 0.8 μm and equal to or smaller than 4.0 μm.

4. The Al bonding wire or the Al bonding ribbon according to any one of claims 1 to 3, further containing 10 mass ppm or more and 800 mass ppm or less of one or more of Sr, Na, Ni, and B in total.

5. The Al bonding wire or the Al bonding ribbon according to any one of claims 1 to 4, further containing 100 mass ppm or more and 2000 mass ppm or less of one or more of Mn, Ti, Fe, Cu, and Mg in total.

6. The Al bonding wire or the Al bonding ribbon according to any one of claims 1 to 5, wherein a total concentration of elements other than Al, Si, Sr, Na, Ni, B, Mn, Ti, Fe, Cu, and Mg in the Al bonding wire or the Al bonding ribbon is equal to or smaller than 0.5 % by mass.

7. The Al bonding wire or the Al bonding ribbon according to any one of claims 1 to 6, wherein the orientation ratios of the crystal orientations are values measured by using a SEM-EDS-EBSD apparatus.

8. The Al bonding wire or the Al bonding ribbon according to any one of claims 2 to 7, wherein the average diameter is a value measured by using a SEM-EDS-EBSD apparatus.

9. The Al bonding wire or the Al bonding ribbon according to any one of claims 1 to 8, used for a semiconductor device.

10. A semiconductor device comprising the Al bonding wire or the Al bonding ribbon according to any one of claims 1 to 9.

FIG.1

ND
1
11
RD
10

FIG.2

2
21
ND
W
20
RD
T

FIG.3

3
30
K
J
31

**INTERNATIONAL SEARCH REPORT**

International application No.
**PCT/JP2024/042018**

**A. CLASSIFICATION OF SUBJECT MATTER**

***H01L 21/60***(2006.01)i; ***C22C 21/02***(2006.01)i; ***C22F 1/00***(2006.01)i; ***C22F 1/043***(2006.01)i
FI: H01L21/60 301F; C22C21/02; C22F1/00 605; C22F1/00 614; C22F1/00 625; C22F1/00 630G; C22F1/00 650A; C22F1/00 661Z; C22F1/00 681; C22F1/00 682; C22F1/00 685Z; C22F1/00 686A; C22F1/00 691B; C22F1/00 691C; C22F1/00 691Z; C22F1/00 694A; C22F1/00 694Z; C22F1/043

According to International Patent Classification (IPC) or to both national classification and IPC

**B. FIELDS SEARCHED**

Minimum documentation searched (classification system followed by classification symbols)

H01L21/60; C22C21/02-21/04; C22F1/00; C22F1/043

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2010-140993 A (FUJI ELECTRIC SYSTEMS CO., LTD.) 24 June 2010 (2010-06-24) | 1-10 |
| A | WO 2022/168787 A1 (NIPPON MICROMETAL CORPORATION) 11 August 2022 (2022-08-11) | 1-10 |
| A | WO 2022/168794 A1 (NIPPON MICROMETAL CORPORATION) 11 August 2022 (2022-08-11) | 1-10 |

☐ Further documents are listed in the continuation of Box C.     ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **14 January 2025** | **28 January 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/042018**

| Patent document cited in search report | Publication date (day/month/year) | Patent family member(s) | Publication date (day/month/year) |
|---|---|---|---|
| JP 2010-140993 A | 24 June 2010 | (Family: none) | |
| WO 2022/168787 A1 | 11 August 2022 | US 2024/0071978 A1 | |
| | | EP 4289983 A1 | |
| | | CN 116918049 A | |
| | | TW 202235634 A | |
| WO 2022/168794 A1 | 11 August 2022 | US 2024/0312946 A1 | |
| | | EP 4289986 A1 | |
| | | CN 116848624 A | |
| | | TW 202239982 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2014131010 A
- JP 2014129578 A
- JP 59057440 A
- JP 2020150116 A